(19) Europäisches Patentamt
European Patent Office
Office européen des brevets

(11) **EP 1 647 010 B1**

(12) **EUROPÄISCHE PATENTSCHRIFT**

(45) Veröffentlichungstag und Bekanntmachung des Hinweises auf die Patenterteilung:
**06.09.2017 Patentblatt 2017/36**

(21) Anmeldenummer: **04763200.5**

(22) Anmeldetag: **13.07.2004**

(51) Int Cl.:
***G10L 19/16*** *(2013.01)*

(86) Internationale Anmeldenummer:
**PCT/EP2004/007744**

(87) Internationale Veröffentlichungsnummer:
**WO 2005/013491 (10.02.2005 Gazette 2005/06)**

(54) **AUDIODATEIFORMATUMWANDLUNG**

AUDIO FILE FORMAT CONVERSION

CONVERSION D'UN FORMAT DE FICHIER AUDIO

(84) Benannte Vertragsstaaten:
**AT BE BG CH CY CZ DE DK EE ES FI FR GB GR HU IE IT LI LU MC NL PL PT RO SE SI SK TR**

(30) Priorität: **21.07.2003 DE 10333071**
**27.08.2003 DE 10339498**

(43) Veröffentlichungstag der Anmeldung:
**19.04.2006 Patentblatt 2006/16**

(73) Patentinhaber: **Fraunhofer-Gesellschaft zur Förderung der angewandten Forschung e.V.**
**80686 München (DE)**

(72) Erfinder:
• **GEYERSBERGER, Stefan**
**97076 Wuerzburg (DE)**
• **GERNHARDT, Harald**
**90562 Heroldsberg (DE)**
• **GRILL, Bernhard**
**91207 Lauf (DE)**
• **HAERTL, Michael**
**84172 Buch am Erlbach (DE)**
• **HILPERT, Johann**
**90411 Nuernberg (DE)**
• **LUTZKY, Manfred**
**90427 Nuernberg (DE)**
• **WEISHART, Martin**
**90760 Fuerth (DE)**
• **POPP, Harald**
**90587 Tuchenbach (DE)**

(74) Vertreter: **Zimmermann, Tankred Klaus et al**
**Schoppe, Zimmermann, Stöckeler**
**Zinkler, Schenk & Partner mbB**
**Patentanwälte**
**Radlkoferstrasse 2**
**81373 München (DE)**

(56) Entgegenhaltungen:
**EP-A- 1 420 401     US-A1- 2003 009 246**

• **FINLAYSON R: "A more loss tolerant RTP payload format for MP3 audio" Juni 2001 (2001-06), XP002251453 Gefunden im Internet: URL:http://www.faqs.org/rfcs/rfc3119.html> [gefunden am 2003-08-15]**

**Beschreibung**

Die vorliegende Erfindung bezieht sich auf Audiosignale codierende Audiodatenströme und genauer auf die bessere Handhabbarkeit von Audiodatenströmen in einem Dateiformat, bei dem die zu einer Zeitmarke gehörenden Audiodaten auf verschiedene Datenblöcke verteilt sein können, wie es beispielsweise bei dem MP3-Format der Fall ist.

Die MPEG-Audiokompression ist eine besonders effektive Form, Audiosignale, wie z.B. Musik oder den Ton zu einem Film, in digitaler Form zu speichern, und dabei aber einerseits so wenig Speicherplatz wie möglich zu benötigen und andererseits die Audioqualität so gut wie möglich zu erhalten. Die MPEG-Audiokompression erwies sich dabei in den letzten Jahren als eine der erfolgreichsten Lösungen auf diesem Gebiet.

Mittlerweile existieren verschiedene Versionen der MPEG-Audiokompressionsverfahren. Allgemein wird das Audiosignal mit einer gewissen Abtastrate abgetastet, wobei die sich ergebende Folge von Audioabtastwerten sich überlappenden Zeitabschnitten bzw. Zeitmarken zugeordnet werden. Diese Zeitmarken werden dann einzeln beispielsweise einer Hybridfilterbank bestehend aus Polyphase und einer modifizierten diskreten Cosinus-Transformation (MDCT) zugeführt, die Aliasing-Effekte unterdrückt. Die eigentliche Datenkomprimierung findet nun bei der Quantisierung der MDCT-Koeffizienten statt. Die so quantisierten MDCT-Koeffizienten werden dann noch in einen Hufmann-Code aus Hufmann-Codewörtern umgewandelt, der eine weitere Komprimierung dadurch erzeugt, daß häufiger auftretenden Koeffizienten kürzere Codewörter zugeordnet werden. Insgesamt sind die MPEG-Komprimierungen somit verlustbehaftet, wobei sich jedoch die "hörbaren" Verluste in Grenzen halten, da psychoakustische Kenntnisse in die Art und Weise der Quantisierung der DCT-Koeffizienten eingeflossen sind.

Ein weit verbreiteter MPEG-Standard ist der sogenannte MP3-Standard wie er in ISO/IEC 11172-3 und 13818-3 beschrieben ist. Dieser Standard läßt eine Anpassung des durch die Komprimierung erzeugten Informationsverlustes an die Bitrate, mit der die Audioinformationen in Echtzeit übertragen werden sollen, zu. Auch bei anderen MPEG-Standards soll die Übertragung des komprimierten Datensignals bei einem Kanal mit konstanter Bitrate erfolgen können. Um nun zu gewährleisten, daß auch bei niedrigen Bitraten die Hörqualität am empfangenden Decodierer ausreichend bleibt, ist es bei dem MP3-Standard vorgesehen, daß ein MP3-Codierer über eine sogenannte Bitsparkasse verfügt. Dies bedeutet folgendes. Normalerweise sollte aufgrund der festen Bitrate der MP3-Codierer jede Zeitmarke in einen gleich großen Block von Codewörtern codieren, dieser Block könnte dann bei gegebener Bitrate in der Zeitdauer der Zeitdauerwiederholrate übertragen werden. Dies würde jedoch nicht dem Umstand Rechnung tragen, daß manche Teile eines Audiosignals, wie z.B. die auf einen sehr lauten Ton folgenden Töne in einem Musikstück, einer weniger genauen Quantisierung bei gleichbleibender Qualität benötigen als andere Teile des Audiosignals, wie z.B. Stellen mit einer Vielzahl unterschiedlicher Instrumente. Ein MP3-Codierer erzeugt deshalb nicht ein einfaches Bitstromformat, bei dem jede Zeitmarke in einem Frame mit für alle Frames gleicher Framelänge codiert ist. Ein solches in sich abgeschlossenes Frame setzte sich aus einem Frame-Header, Seiteninformationen und den zu der dem Frame zugeordneten Zeitmarke gehörenden Hauptdaten, nämlich den codierten MDCT-Koeffizienten, zusammen, wobei die Seiteninformationen Informationen an den Decodierer sind, wie die DCT-Koeffizienten zu entschlüsseln sind, wie z.B. wie viel aufeinanderfolgende DCT-Koeffizienten 0 sind, um anzugeben, welche DCT-Koeffizienten der Reihe nach in den Hauptdaten enthalten sind. Vielmehr ist beim MP3-Format in den Seiteninformationen oder in dem Header ein Rückwärtszeiger wärtszeiger bzw. Backpointer enthalten, der an eine Position innerhalb der Hauptdaten in einen der vorhergehenden Frames zeigt. An dieser Position liegt der Beginn der Hauptdaten, die zu der Zeitmarke gehören, der der Frame zugeordnet ist, in dem der entsprechende Backpointer enthalten ist. Der Backpointer gibt beispielsweise die Anzahl an Bytes an, um die der Beginn der Hauptdaten im Bitstrom verschoben ist. Das Ende dieser Hauptdaten kann in irgendeinem Frame liegen, je nach dem wie hoch die Komprimierungsrate für diese Zeitmarke ist. Die Länge der Hauptdaten der einzelnen Zeitmarken ist damit nicht mehr konstant. Somit kann die Anzahl der Bits, mit denen ein Block codiert wird, an die Eigenschaften des Signals angepaßt werden. Gleichzeitig kann jedoch eine konstante Bitrate erreicht werden. Diese Technik wird "Bitsparkasse" genannt. Allgemein gesagt stellt die Bitsparkasse einen Buffer bzw. Puffer von Bits dar, die eingesetzt werden können, um zum Codieren eines Blocks von zeitlichen Abtastwerten mehr Bits zur Verfügung zu stellen als eigentlich durch die konstante Ausgangsdatenrate erlaubt sind. Die Technik der Bitsparkasse trägt der Tatsache Rechnung, daß manche Blöcke von Audioabtastwerten mit weniger Bits als durch die konstante Übertragungsrate vorgegeben codiert werden können, so daß sich durch diese Blöcke die Bitsparkasse füllt, während wieder andere Blöcke von Audioabtastwerten psychoakustische Eigenschaften haben, die keine so große Kompression ermöglichen, so daß für diese Blöcke zum störungsarmen bzw. störungsfreien Codieren die zur Verfügung stehenden Bits eigentlich nicht ausreichen würden. Die benötigten überzähligen Bits werden der Bitsparkasse entnommen, so daß sich die Bitsparkasse bei solchen Blöcken leert. Die Technik der Bitsparkasse ist ebenfalls in dem oben angegebenen Standard MPEG Layer 3 beschrieben.

So sehr das MP3-Format durch das Vorsehen der Rückwärtszeiger auch Vorteile auf Codierer-Seite haben mag, ergeben sich unstreitig Nachteile auf Decodierer-Seite. Empfängt ein Decodierer beispielsweise einen MP3-Bitstrom nicht von Anfang an sondern ab einem bestimmten Frame in der Mitte, so kann das codierte Audiosignal an der diesem Frame zugeordneten Zeitmarke nur dann sofort abgespielt werden, wenn der Rückwärtszeiger zufällig 0 ist, was anzeigen würde, daß der Beginn der Hauptdaten zu diesem Frame sich zufällig unmittelbar im Anschluß an den Header bzw. die Seiteninformationen befindet. Dies ist jedoch normalerweise nicht der Fall. Ein Abspielen des Audiosignals an dieser Zeitmarke ist folglich nicht möglich, wenn der Rückwärtszeiger des zuerst empfangenen Frames auf einen vorhergehenden Frame verweist, der jedoch (noch) nicht empfangen worden ist. In diesem Fall kann (zunächst) erst der nächste Frame abgespielt werden.

Weitere Probleme ergeben sich empfangsseitig auch beim Umgang mit den Frames allgemein, die durch die Rückwärtszeiger miteinander verknüpft sind und damit nicht in sich abgeschlossen sind. Ein weiteres Problem von Bitströmen mit Rücksprungadressen für eine Bitsparkasse besteht darin, daß, wenn verschiedene Kanäle eines Audiosignals einzeln MP3-codiert werden, in den beiden Bitströmen einander zugehörige, da zur gleichen Zeitmarke gehörige, Hauptdaten eventuell zueinander versetzt sind, und zwar mit über die Folge von Frames variablem Versatz, so daß hierin wiederum eine Zusammenfassung dieser einzelnen MP3-Ströme zu einem Mehrkanal-Audiodatenstrom erschwert wird.

Zudem besteht ein Bedarf an einer einfachen Möglichkeit einfach handhabbare MP3-konforme Mehrkanalaudiodatenströme erzeugen zu können. Multikanal-MP3-Audiodatenströme nach dem ISO/IEC-Standard 13818-3 erfordern Matrizierungsoperationen zur Rückgewinnung der Eingangskanäle aus den übertragenen Kanälen auf Decodiererseite und die Verwendung mehrerer Backpointer und sind deshalb kompliziert in ihrer Handhabung.

MPEG 1/2 layer 2 Audiodatenströme stimmen mit den MP3-Audiodatenströmen in ihrer Zusammensetzung aus aufeinanderfolgenden Frames und in dem Aufbau und der Anordnung der Frames, nämlich dem Aufbau aus Header, Seiteninformationen und Hauptdatenteil überein und der Anordnung mit einem quasi statischen Frameabstand, der von der Abtastrate und der von Frame zu Frame variierbaren Bitrate abhängt, sie unterschieden sich jedoch von denselben durch das Fehlen der Backpointer bzw. der Bitsparkasse bei der Codierung. Codierungsaufwendige und -unaufwendige Zeitabschnitte des Audiosignals werden mit derselben Framelänge codiert. Die zu einer Zeitmarke gehörenden Hauptdaten befinden sich im betreffenden Frame zusammen mit dem betreffenden Header.

Die US-2003/009246 A1 beschreibt eine Trick-Abspiel- und/oder Editiervorrichtung, mit der es möglich ist, MP3-Datenströme auf einfachere Art und Weise zu bearbeiten. Hierzu wird vorgeschlagen, nach dem Einlesen einer MP3-Datei in einem MP3-Bereitsteller die Datei in einem Umwandler zunächst so umzuwandeln, dass ein Zwischen-MP3-Strom entsteht, bei dem die Framedaten zu einem Frame jeweils unmittelbar auf den jeweiligen Bestimmungsblock folgen, so dass die Rückwärtszeiger bzw. Backpointer 0 sind. Bei der Umwandlung wird die zunächst für ein bestimmtes Frame aus dem ursprünglichen MP3-Datenstrom der entsprechende Bestimmungsblock ausgelesen, und in demselben die Bitrate auf einen maximal möglichen Wert oder einen minimal möglichen Wert unter Berücksichtigung der entstehenden Framelänge in dem Zwischen-MP3-Strom eingestellt. Ferner wird das Padding-Bit gesetzt oder nicht gesetzt, je nachdem wie es in dem entstehenden Zwischen-MP3-Strom mit in sich abgeschlossenen Frames notwendig ist. Andere Felder in dem Frameheader werden nicht verändert. Natürlich wird noch der Backpointer-Wert auf Null gesetzt. Daraufhin werden aus dem MP3-Ursprungsdatenstrom die Framedaten zu dem jeweiligen aktuellen Frame ausgelesen und an den neu entstandenen Bestimmungsblock angehängt, woraufhin an die Framenutzdaten noch Füllinformationen angehängt werden, um die Länge des entstehenden in sich abgeschlossenen Frames auf diejenige einzustellen, die durch die veränderte Bitrate vorgegeben ist. Der entstehenden Zwischen-MP3-Datenstrom wird dann einer Trick-Abspiel- und/oder Editiereinheit zugeführt, die an denselben einfache Manipulationen durchführen kann, da nun die Frames in sich abgeschlossen sind. Der so veränderte Zwischen-MP3-Datenstrom wird an einen üblichen MP3-Decodierer weitergeleitet.

In Finlayson R. "A more loss tolerant RTP payload format for MP3 audio", Juni 2001, URL: http://www.faqs.org/rfcs/ rfc3119.htm1 wird eine Umwandlung eines MP3-Datenstromes in ein Echtzeit-Protokoll-Nutzdatenformat, kurz RTP-Format, das in dem Fall des Auftretens von Paket-Verlusten besser geeignet sei, beschrieben. Im Rahmen dieser Umwandlung werden die MP3-Frames zu MP3-Application-Data-Units, kurz ADU-Frames. Jedem ADU-Frame geht ein ADU-Descriptor voran. Ein ADU-Frame unterscheidet sich von dem ursprünglichen MP3-Frame dadurch, dass die komplette Folge von codierten Audiodaten und jegliche andere wahlfreien Daten für die ADU, d.h. diejenigen, die in dem ursprünglichen MP3-Datenstrom an der Stelle beginnen, auf die der Backpointer zeigt, der in dem entsprechenden ursprünglichen MP3-Frame-Header enthalten ist, und an der nächsten Stelle Enden, auf die der Backpointer in dem nächsten MP3-Frame zeigt, in demselben ADU-Frame enthalten ist. Ansonsten unterscheiden sich die solchermaßen in sich abgeschlossenen ADU-Frames von den ursprünglichen MP3-Frames lediglich in der optionalen Ersetzung der ersten 11 Synchronisationsbits in dem MP3-Frameheader durch eine Verschaltungssequenznummer, die dazu vorgesehen ist, es wahlweise zu ermöglichen, die Abfolge von ADU-Frames für die Übertragung abweichend von der eigentlichen zeitlichen Reihenfolge umzusortieren. Die den solchermaßen gebildeten ADU-Frames hinzugefügten ADU-Descriptoren enthalten drei Felder, nämlich einen Kontinuitätsflag, einen Descriptortypflag und eine ADU-Größenangabe, die die Größe des auf den jeweiligen ADU-Descriptor folgenden ADU-Frames angibt. Diese Paare von ADU-Frame und ADU-Descriptor werden in RTP-Pakete gepackt, die wiederum RTP-Header aufweisen. Passt ein Paar aus ADU-Frame und ADU-Descriptor nicht in ein solches Paket, so wird es auf zwei aufeinanderfolgende RTP-Pakete verteilt. In diesem Fall wird in dem ADU-Descriptor des Folge-ADU-Frames das Continuationflag gesetzt. Das Descriptortypflag gibt lediglich an, wie viel Bits die ADU-Größenangabe in dem ADU-Descriptor enthält. Die RTP-Headerfelder umfassen unter anderem eine Zeitmarkenangabe, die den Wiedergabezeitpunkt der ersten ADU angibt, die in das jeweilige Paket gepackt ist. Dieser RTP-Paketdatenstrom mit eventuell verschachtelten ADU-Frame könne dann wieder ohne weiteres in einen üblichen MP3-Datenstrom umgewandelt werden, nämlich den ursprünglichen MP3-Datenstrom.

Es ist die Aufgabe der vorliegenden Erfindung, ein Schema zum Umwandeln eines Audiodatenstroms in einen weiteren Audiodatenstrom oder umgekehrt zu schaffen, so daß die Handhabung mit den Audiodaten erleichtert wird, wie z.B. im Hinblick auf die Zusammenfassung einzelner Audiodatenströme zu Mehrkanal-Audiodatenströmen oder die Handhabung eines Audiodatenstroms allgemein.

Diese Aufgabe wird durch ein Verfahren gemäß Anspruch 1 oder 8 und eine Vorrichtung gemäß Anspruch 9 oder 11 gelöst.

Die Handhabung mit Audiodaten kann erleichtert werden, wie z.B. im Hinblick auf die Zusammenfassung einzelner Audiodatenströme zu Mehrkanal-Audiodatenströmen oder die Handhabung eines Audiodatenstroms allgemein, indem in einem Audiodatenstrom, der in Datenblöcke mit Bestimmungsblock und Datenblockaudiodaten gegliedert ist, ein Datenblock modifiziert wird, wie z.B. durch Ergänzung bzw. Hinzufügung oder durch Ersetzung eines Teils desselben, damit derselbe eine Längenangabe enthält, die eine Datenmenge bzw. Länge der Datenblockaudiodaten oder eine Datenmenge bzw. Länge des Datenblocks angibt, um einen zweiten Audiodatenstrom mit modifizierten Datenblöcken zu erhalten. Oder es wird ein Audiodatenstrom mit Zeigern in Bestimmungsblöcken, die auf die den Bestimmungsblöcken zugeordneten aber in verschiedene Datenblöcke verteilten Bestimmungsblockaudiodaten zeigen, in einen Audiodatenstrom überführt, bei dem die Bestimmungsblockaudiodaten zu zusammenhängenden Bestimmungsblockaudiodaten zusammengefasst sind. Die zusammenhängenden Bestimmungsblockaudiodaten können dann zusammen mit ihrem Bestimmungsblock in einem in sich abgeschlossenem Kanalelement enthalten sein.

Eine Erkenntnis der vorliegenden Erfindung besteht darin, daß ein zeigerbasierter Audiodatenstrom, bei dem ein Zeiger auf den Anfang der Bestimmungsblockaudiodaten des entsprechenden Datenblocks zeigt, leichter handhabbar ist, wenn dieser Audiodatenstrom manipuliert wird, damit in ihm alle Bestimmungsblockaudiodaten, d.h. Audiodaten, die ein und dieselbe Zeitmarke betreffen bzw. die Audiowerte zu ein und derselben Audiomarke codieren, zu einem zusammenhängenden Block von zusammenhängenden Bestimmungsblockaudiodaten zusammengefasst sind, und an diesen der jeweilige Bestimmungsblock gehängt ist, dem die zusammenhängenden Bestimmungsblockaudiodaten zugeordnet sind. Die so erhaltenen Kanalelemente ergeben nach Anordnung bzw. Aneinanderreihung derselben den neuen Audiodatenstrom, bei dem alle Audiodaten, die zu einer Zeitmarke gehören bzw. die Audio- bzw. Abtastwerte zu dieser Zeitmarke codieren, auch in einem Kanalelement zusammengefaßt sind, so daß der neue Audiodatenstrom leichter handhabbar ist.

Gemäß einem Ausführungsbeispiel der vorliegenden Erfindung wird bei dem neuen Audiodatenstrom jeder Bestimmungsblock oder jedes Kanalelement modifiziert, wie z.B. durch Hinzufügung oder durch Ersetzung eines Teils, um eine Längenangabe zu enthalten, die die Länge bzw. Datenmenge des Kanalelements oder die der darin enthaltenen zusammenhängenden Audiodaten angibt, um so die Decodierung des neuen Audiodatenstroms mit Kanalelementen variabler Länge zu erleichtern. Vorteilhafterweise wird die Modifikation dadurch durchgeführt, daß ein für alle Bestimmungsblöcke des Eingangsaudiodatenstromes identischer, redundanter Teil dieser Bestimmungsblöcke durch die jeweilige Längenangabe ersetzt wird. Durch diese Maßnahme kann es erzielt werden, daß die Datenbitrate des sich ergebenden Audiodatenstroms trotz der im Vergleich zum ursprünglichen zeigerbasierten Audiodatenstrom zusätzlichen Längenangabe gleich derjenigen des ursprünglichen Audiodatenstromes ist, und daß dabei ferner der im neuen Audiodatenstrom nun eigentlich unnötige Rückwärtszeiger erhalten werden kann, um den ursprünglichen Audiodatenstrom noch aus dem neuen Audiodatenstrom rekonstruieren zu können.

Der identische, redundante Teil dieser Bestimmungsblöcke kann in einem Gesamtbestimmungsblock an dem sich ergebenden neuen Audiodatenstrom vorangestellt werden. Empfangsseitig kann somit der sich ergebende zweite Audiodatenstrom in den ursprünglichen Audiodatenstrom zurück umgewandelt werden, um somit bereits existierende Decodierer, die nur zur Decodierung von Audiodatenströmen des ursprünglichen Dateiformats in der Lage sind, zur Decodierung des sich ergebenden Audiodatenstroms in dem zeigerlosen Format zu verwenden.

Gemäß einem weiteren Ausführungsbeispiel der vorliegenden Erfindung wird eines Umwandlung eines ersten Audiodatenstromes in einen zweiten Audiodatenstrom eines anderen Dateiformats dazu verwendet, aus mehreren Audiodatenströmen des ersten Dateiformats einen Mehrkanalaudiodatenstrom zu bilden. Eine empfangsseitige Handhabbarkeit ist gegenüber dem reinen Zusammenfügen der ursprünglichen Audiodatenströme mit Zeiger verbessert, da in dem Mehrkanalaudiodatenstrom alle Kanalelemente, die zu einer Zeitmarke gehören bzw. die zusammenhängende Bestimmungsblockaudiodaten enthalten, durch Codierung eines zeitgleichen Zeitabschnitts eines Kanals eines Mehrkanalaudiosignals, d.h. durch Codierung von Zeitabschnitten verschiedner Kanäle, die zur selben Zeitmarke gehören, erhalten wurden, zu ZugriffsEinheiten bzw. Access-Units zusammengefaßt werden können. Dies ist bei zeigerbasierten Audiodatenformaten nicht möglich, da dort die Audiodaten zu einer Zeitmarke auf unterschiedliche Datenblöcke verteilt sein können. Das Versehen von Datenblöcken in mehreren Audiodatenströmen zu verschiedenen Kanälen mit einer Längenangabe ermöglicht bei Zusammenfassung der Audiodatenströme zu einem Mehrkanaldatenstrom mit Zugriffseinheiten ein besseres Parsen durch die Zugriffseinheiten.

Die vorliegende Erfindung ist ferner aus der Erkenntnis daraus entstanden, daß es sehr einfach ist, die oben beschriebenen sich ergebenden Audiodatenströme wieder in ein ursprüngliches Dateiformat umzuwandeln, welches dann von bestehenden Dekodierern in das Audiosignal dekodiert werden kann. Obwohl nämlich die entstehenden Kanalelemente eine unterschiedliche Länge aufweisen und somit mal länger und mal kürzer als die in einem Datenblock des ursprünglichen Audiodatenstroms zur Verfügung stehende Länge ist, ist es zum Abspielen des Audiodatenstromes im neuen Dateiformat nicht nötig, die Hauptdaten gemäß den gegebenenfalls unnötigerweise noch erhaltenen Rückwärtszeigern zu versetzen bzw. zusammenzuschieben, sondern es reicht aus, eine Bitratenangabe in den Bestimmungsblöcken des zu erstellenden Audiodatenstroms des ursprünglichen Dateiformats zu erhöhen. Der Effekt hiervon ist, daß gemäß dieser Bitratenangabe auch die längste unter den Kanalelementen in dem zu dekodierenden Audiodatenstrom kleiner oder gleich lang wie die Datenblocklänge ist, die Datenblöcke in einem Audiodatenstrom des ersten Dateiformat haben. Die Rückwärtszeiger werden auf Null gesetzt, und die Kanalelemente werden durch Anfügen von Bits unbeachtlichen Werts (don't care) auf die der erhöhten Bitratenangabe entsprechende Länge verlängert. Es entstehen somit Datenblöcke eines Audiodatenstromes im ursprünglichen Dateiformat, in denen die zugehörigen Hauptdaten ausschließlich im Datenblock selbst und nicht in einem anderen enthalten sind. Ein derart rückkonvertierter Audiodatenstrom des ersten Dateiformats kann dann einem bereits bestehenden Decodierer für Audiodatenströme des ersten Datenformats unter Verwendung der gemäß der erhöhten Bitangabe erhöhten Bitrate zugeführt werden. Aufwendige Verschiebeoperationen zur Rückkonvertierung entfallen folglich ebenso wie die Notwendigkeit, bereits bestehende Decodierer durch neue ersetzen zu müssen.

Andererseits ist es gemäß einem weiteren Ausführungsbeispiel möglich, den ursprünglichen Audiodatenstrom aus dem sich ergebenden Audiodatenstrom wiederzugewinnen, indem die in dem Gesamtbestimmungsblock des sich ergebenden Audiodatenstroms enthaltenen Informationen über den identischen, redundanten Teil der Bestimmungsblöcke verwendet wird, um den durch die Längenangabe überschriebenen Teil wieder herzustellen.

Bevorzugte Ausführungsbeispiele der vorliegenden Erfindung werden nachfolgend Bezug nehmend auf die beiliegenden Zeichnungen näher erläutert. Es zeigen:

Fig. 1  eine schematische Zeichnung zur Veranschaulichung des MP3-Dateiformats mit Backpointer;

Fig. 2  ein Blockschaltbild zur Veranschaulichung eines Aufbaus zur Umwandlung eines MP3-Audiodatenstroms in einen MPEG-4-Audiodatenstrom;

Fig. 3  ein Flußdiagramm eines Verfahrens zur Umwandlung eines MP3-Audiodatenstroms in einen MPEG-4-Audiodatenstrom gemäß einem Ausführungsbeispiel der vorliegenden Erfindung;

Fig. 4  eine schematische Zeichnung zur Veranschaulichung des Schritt des Zusammenfassens zusammengehöriger Audiodaten unter Anfügung der Bestimmungsblöcke und des Schritts des Modifizierens der Bestimmungsblöcke in dem Verfahren nach Fig. 3;

Fig. 5  eine schematische Zeichnung zur Veranschaulichung eines Verfahrens zur Umwandlung mehrerer MP3-Audiodatenströme zu einem Mehrkanal-MPEG-4-Audiodatenstrom gemäß einem weiteren Ausführungsbeispiel der vorliegenden Erfindung;

Fig. 6  ein Blockschaltbild einer Anordnung zur Umwandlung eines nach Fig. 3 erhaltenen MPEG-4-Audiodatenstromes zurück in einen MP3-Audiodatenstrom, um denselben durch bestehende MP3-Dekodierer dekodieren zu können;

Fig. 7  ein Flußdiagramm eines Verfahrens zum Rückumwandeln des nach Fig. 3 erhaltenen MPEG-4-Audiodatenstromes in einen bzw. mehrere Audiodatenströme im MP3-Format;

Fig. 8  ein Flußdiagramm eines Verfahrens zum Rückumwandeln des nach Fig. 3 erhaltenen MPEG-4-Audiodatenstromes in einen bzw. mehrere Audiodatenströme im MP3-Format gemäß einem weiteren Ausführungsbeispiel der vorliegenden Erfindung; und

Fig. 9  ein Flußdiagramm eines Verfahrens zur Umwandlung eines MP3-Audiodatenstroms in einen MPEG-4-Audiodatenstrom gemäß einem weiteren Ausführungsbeispiel der vorliegenden Erfindung.

Die vorliegende Erfindung wird im folgenden Bezug nehmend auf die Figuren anhand von Ausführungsbeispielen beschrieben, bei denen es sich lediglich exemplarisch bei dem ursprünglichen Audiodatenstrom in einem Dateiformat, bei dem Backpointer in Bestimmungsblöcken der Datenblöcke zum Verweis auf den Anfang der zu dem Bestimmungsblock gehörigen Hauptdaten verwendet werden, um einen MP3-Audiodatenstrom handelt, während es sich bei dem sich ergebenden Audiodatenstrom, der sich aus in sich abgeschlossen Kanalelementen zusammensetzt, in denen die zu der jeweiligen Zeitmarke gehörigen Audiodaten jeweils zusammengefaßt sind, ebenfalls lediglich exemplarisch um einen MPEG-4-Audiodatenstrom handelt. Das MP3-Format ist in der in der Beschreibungseinleitung zitierten Standard ISO/IEC 11172-3 und 13818-3 beschrieben, während das MPEG-4-Dateiformat im Standard ISO/IEC 14496-3 beschrieben ist.

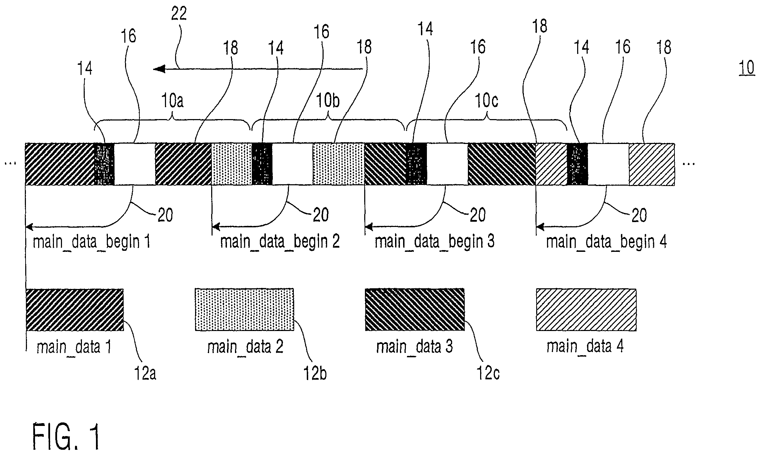

Zunächst wird Bezug nehmend auf Fig. 1 das MP3-Format kurz erläutert. Fig. 1 zeigt einen Ausschnitt eines MP3-Audiodatenstroms 10. Der Audiodatenstrom 10 besteht aus einer Folge von Frames bzw. Datenblöcken, von denen in Fig. 1 nur drei vollständig zu sehen sind, nämlich 10a, 10b und 10c. Der MP3-Audiodatenstrom 10 ist von einem MP3-Codierer aus einem Audio- bzw. Tonsignal erzeugt worden. Das durch den Datenstrom 10 codierte Audiosignal ist beispielsweise Musik, Sprache, eine Mischung derselben oder dergleichen. Die Datenblöcke 10a, 10b und 10c sind jeweils einem von aufeinanderfolgenden, sich gegebenenfalls überlappenden Zeitabschnitten zugeordnet, in die das Audiosignal durch den MP3-Codierer aufgeteilt worden ist. Jeder Zeitabschnitt entspricht einer Zeitmarke des Audiosignals und für die Zeitabschnitte wird in der Beschreibung deshalb häufig auch der Begriff Zeitmarke verwendet. Jeder Zeitabschnitt ist durch den MP3-Codierer einzeln durch beispielsweise eine Hybridfilterbank bestehend aus einer Polyphase-Filterbank und einer modifizierten diskreten Cosinustransformation mit anschießender Entropie-, wie z.B. Huffman-, -codierung in Hauptdaten (main_data) codiert worden. Die Hauptdaten, die zu den aufeinanderfolgenden drei Zeitmarken gehören, denen die Datenblöcke 10a-10c zugeordnet sind, sind in Fig. 1 mit 12a, 12b und 12c als zusammenhängende Blöcke abseits des eigentlichen Audiodatenstroms 10 veranschaulicht.

Die Datenblöcke 10a-10c des Audiodatenstroms 10 sind im Audiodatenstrom 10 äquidistant angeordnet. Das bedeutet wiederum, daß jeder Datenblock 10a-10c dieselbe Datenblocklänge bzw. Framelänge aufweist. Die Framelänge hängt wiederum von der Bitrate ab, bei denen der Audiodatenstrom 10 in Echtzeit mindestens abspielbar sein soll, und von der Abtastrate, die der MP3-Codierer zur Abtastung des Audiosignals vor der eigentlichen Codierung verwendet hat. Der Zusammenhang ist der, daß die Abtastrate in Verbindung mit der festen Anzahl an Abtastwerten pro Zeitmarke angibt, wie lang eine Zeitmarke ist, und sich aus der Bitrate und der Zeitmarkendauer berechnen läßt, wie viele Bits in dieser Zeitdauer übertragen werden können.

Beide Parameter, d.h. Bitrate und Abtastrate, sind in Frame-Headern 14 in den Datenblöcken 10a-10c angegeben. Jeder Datenblock 10a-10c besitzt somit selbst einen Frame-Header 14. Überhaupt sind alle zur Decodierung des Audiodatenstroms wichtigen Informationen in jedem Frame 10a-10c selbst gespeichert, so daß es einem Decodierer möglich ist, die Decodierung in der Mitte eines MP3-Audiodatenstroms 10 zu beginnen.

Neben dem Frame-Header 14, der sich am Anfang befindet, besitzt jeder Datenblock 10a-10c noch einen Seiteninformationsteil 16 und einen Hauptdatenteil 18, welcher Datenblockaudiodaten enthält. Der Seiteninformationsteil 16 folgt dem Header 14 unmittelbar. In ihm sind Informationen enthalten, die für den Decodierer des Audiodatenstroms 10 unerläßlich sind, um die dem jeweiligen Datenblock zugeordneten Hauptdaten bzw. die Bestimmungsblockaudiodaten, die ja lediglich in Reihe linear abgelegte Hufmann-Codewörter sind, aufzufinden und auf richtige Weise zu den DCT- bzw. MDCT-Koeffizienten zu decodieren. Der Hauptdatenteil 18 bildet das Ende jeden Datenblocks.

Wie in der Beschreibungseinleitung erwähnt, unterstützt der MP3-Standard eine Sparkassen-Funktion. Diese wird ermöglicht durch in den Seiteninformationen innerhalb des Seiteninformationsteils 16 enthaltene Backpointer, die in Fig. 1 mit 20 angezeigt sind. Steht ein Backpointer auf 0, so beginnen die Hauptdaten zu diesen Seiteninformationen unmittelbar im Anschluß an den Seiteninformationsteil 16. Anderenfalls gibt der Zeiger 20 (main_data_begin) den Beginn der Hauptdaten, die die Zeitmarke codieren, der der Datenblock zugeordnet ist, in der die den Backpointer 20 enthaltenen Seiteninformationen 16 umfaßt sind, in einem vorhergehenden Datenblock an. In Fig. 1 ist beispielsweise der Datenblock 10a einer Zeitmarke zugeordnet, die durch die Hauptdaten 12a codiert wird. Der Backpointer 20 in den Seiteninformationen 16 dieses Datenblocks 10a verweist beispielsweise durch Angabe eines Bit- oder Byteversatzes gemessen von Beginn des Headers 14 des Datenblocks 16a an auf den Beginn der Hauptdaten 12a, der sich in einem Datenblock in Stromrichtung 22 vor dem Datenblock 10a befindet. Dies bedeutet, daß zu diesem Zeitpunkt bei der Codierung des Audiosignals die Bitsparkasse des den MP3-Audiodatenstrom 10 erzeugenden MP3-Codierers nicht voll war, sondern noch um die Höhe des Backpointers belastet werden konnte. Von der Position an, auf die der Backpointer 20 des Datenblocks 10a deutet, sind die Hauptdaten 12a in den Audiodatenstrom 10 mit den äquidistant angeordneten Paaren von Headern und Seiteninformationen 14, 16 eingefügt. In dem vorliegenden Beispiel erstrecken sich die Hauptdaten 12a bis etwas über die Hälfte des Hauptdatenteils 18 des Datenblocks 10a. Der Backpointer 20 im Seiteninformationsteil 16 des nachfolgenden Datenblocks 10b zeigt an eine Position unmittelbar im Anschluß an die Hauptdaten 12a im Datenblock 10a. entsprechend verhält es sich mit dem Backpointer 20 in dem Seiteninformationsteil 16 des Datenblocks 10c.

Wie es zu erkennen ist, ist bei dem MP3-Audiodatenstrom 10 eher die Ausnahme, wenn sich die zu einer Zeitmarke gehörenden Hauptdaten tatsächlich ausschließlich in dem dieser Zeitmarke zugeordneten Datenblock befinden. Vielmehr sind die Datenblöcke zumeist auf einen oder mehrere Datenblöcke verteilt, worunter sich je nach Größe der Bitsparkasse nicht einmal der entsprechende Datenblock selbst befinden muß. Die Höhe des Backpointerwertes ist durch die Größe der Bitsparkasse begrenzt.

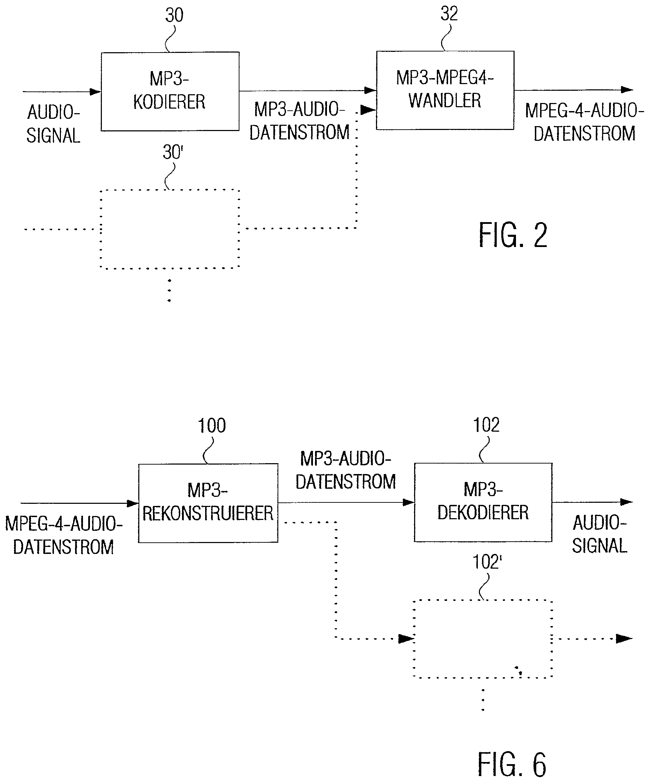

Nachdem anhand von Fig. 1 der Aufbau eines MP3-Audiodatenstroms beschrieben worden ist, wird Bezug nehmend auf Fig. 2 eine Anordnung beschrieben, die geeignet ist, um einen MP3-Audiodatenstrom in einen MPEG-4-Audiodatenstrom umzuwandeln, oder um aus einem Audiosignal einen ohne weiteres in ein MP3-Format umwandelbaren MPEG-4-Audiodatenstrom zu erhalten.

Fig. 2 zeigt einen MP3-Codierer 30 und einen MP3-MPEG4-Wandler 32. Der MP3-Codierer 30 umfaßt einen Eingang, an dem derselbe ein zu codierendes Audiosignal erhält, und einen Ausgang, an dem derselbe einen MP3-Audiodatenstrom ausgibt, das das Audiosignal am Eingang codiert. Der MP3-codierer 30 arbeitet nach dem vorerwähnten MP3-Standard.

Der MP3-Audiodatenstrom, dessen Aufbau Bezug nehmend auf Fig. 1 erläutert wurde, besteht wie erwähnt aus Frames fester Framelänge, welche letztere von einer eingestellten Bitrate und der zugrundeliegenden Abtastrate abhängt sowie von einem gesetzten oder nicht gesetzten Paddingbyte. Der MP3-MPEG4-Wandler 32 empfängt den MP3-Audiodatenstrom an einem Eingang und gibt an einem Ausgang einen MPEG-4-Audiodatenstrom aus, dessen Aufbau sich aus der nachfolgenden Beschreibung der Funktionsweise des MP3-MPEG4-Wandlers 32 ergibt. Sinn und Zweck des Wandlers 32 besteht darin, den MP3-Audiodatenstrom von dem MP3-Format in das MPEG-4-Format umzuwandeln. Das MPEG-4-Datenformat besitzt den Vorteil, daß in ihm alle zu einer bestimmten Zeitmarke gehörenden Hauptdaten in einer zusammenhängenden Access-Unit oder einem Kanalelement enthalten sind, so daß die Handhabung des letztgenannten bedeutend einfacher ist.

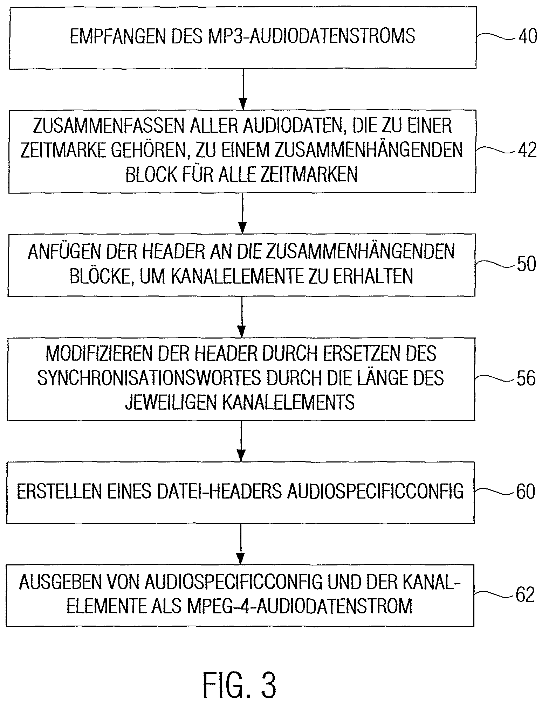

Fig. 3 zeigt die einzelnen Verfahrensschritte bei der Umwandlung des MP3-Audiodatenstroms in den MPEG-4-Audiodatenstrom, die von dem Wandler 32 ausgeführt werden. Zunächst wird in einem Schritt 40 der MP3-Audiodatenstrom empfangen. Der Empfang kann das Abspeichern des vollständigen Audiodatenstroms oder lediglich eines aktuellen Teils davon in einem Zwischenspeicher umfassen. Dementsprechend können die nachfolgenden Schritte bei der Umwandlung entweder noch während des Empfangsvorganges 40 in Echtzeit oder erst im Anschluß daran durchgeführt werden.

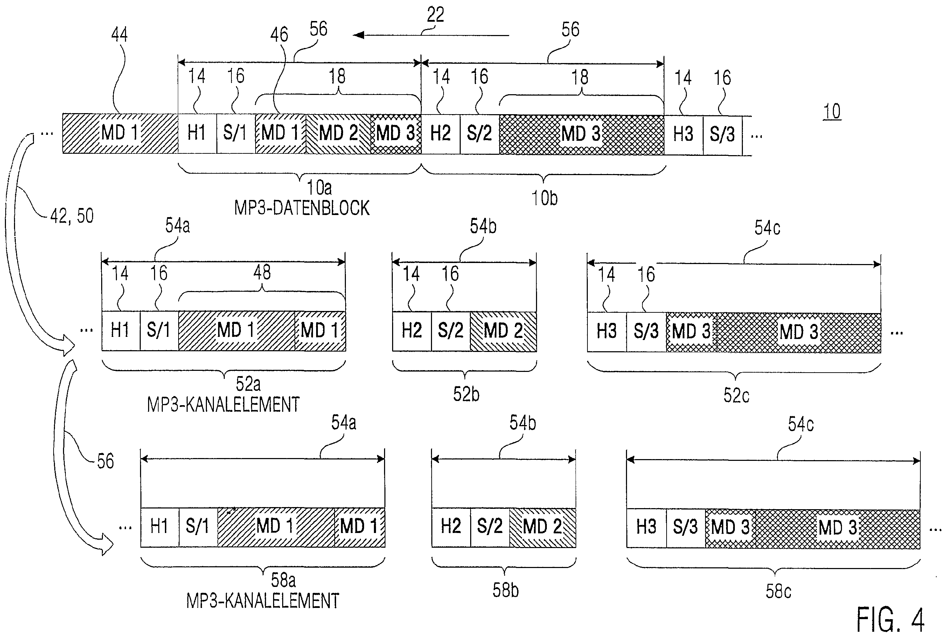

In einem Schritt 42 werden sodann alle Audiodaten bzw. Hauptdaten, die zu einer Zeitmarke gehören, zu einem zusammenhängenden Block zusammengefaßt, und zwar dies für alle Zeitmarken. Der Schritt 42 ist in Fig. 4 schematisch näher veranschaulicht, wobei in dieser Figur die zu den in Fig. 1 dargestellten Elementen eines MP3-Audiodatenstroms ähnlichen Elemente mit gleichen oder ähnlichen Bezugszeichen versehen sind, und eine wiederholte Beschreibung dieser Elemente vermieden wird.

Wie es aus der Datenstromrichtung 22 erkenntlich ist, gelangen die in Fig. 4 weiter links dargestellten Teile des MP3-Audiodatenstroms 10 früher zu dem Wandler 32 als die rechten Teile desselben. Zwei Datenblöcke 10a und 10b sind in Fig. 4 vollständig dargestellt. Die Zeitmarke, die zu dem Datenblock 10a gehört, wird durch die Hauptdaten MD1 codiert, die in Fig. 4 exemplarisch zum Teil in einem Datenblock vor dem Datenblock 10a und zum anderen Teil in dem Datenblock 10a, und zwar insbesondere im Hauptdatenteil 18 derselben - enthalten sind. Diejenigen Hauptdaten, die die Zeitmarke codieren, der der nachfolgende Datenblock 10b zugeordnet ist, sind ausschließlich in dem Hauptdatenteil 18 des Datenblocks 10a enthalten und mit MD2 bezeichnet. Die einem auf den Datenblock 10b folgenden Datenblock angehörenden Hauptdaten MD3 sind über die Hauptdatenteile 18 der Datenblöcke 10a und 10b verteilt.

In dem Schritt 42 fügt nun der Wandler 32 alle zusammengehörenden, d.h. alle ein und dieselbe Zeitmarke codierenden, Hauptdaten zu zusammenhängenden Blöcken zusammen. So ergeben der sich vor dem Datenblock 10a befindliche Abschnitt 44 und der sich in dem Hauptdatenteil 18 des Datenblocks 10a befindliche Abschnitt 46 der Hauptdaten MD1 nach dem Schritt 42 zusammen durch Aneinanderfügen den zusammenhängenden Block 48. Entsprechend wird für die anderen Hauptdaten MD2, MD3 .... vorgegangen.

Zur Durchführung des Schritts 42 liest der Wandler 32 den Zeiger in den Seiteninformationen 16 eines Datenblocks 10a und daraufhin, auf der Basis dieses Zeigers, den jeweils ersten Teil 44 der Bestimmungsblockaudiodaten 12a zu diesem Datenblock 10a, der in dem Feld 18 eines vorhergehenden Datenblocks enthalten ist, und zwar beginnend an der durch den Zeiger festgelegten Stelle bis zu dem Header des aktullen Datenblocks 10a. Den zweiten Teil 46 der Bestimmungsblockaudiodaten, der im Teil 18 des aktuellen Datenblocks 10a enthalten ist und das Ende der Bestimmungsblockaudiodaten zu diesem Datenblock 10a umfasst, liest er danach beginnend vom Ende der Seiteninformationen 16 des aktuellen Audiodatenblocks 10a bis zum Anfang der nächsten Audiodaten, hier als MD2 bezeichnet, zu dem nächsten Datenblock 10b, auf den ja der Zeiger in den Seiteninformationen 16 des nachfolgenden Datenblocks 10b zeigt, die der Wandler 32 ebenfalls liest. Anfügen der beiden Teile 44 und 46 ergibt, wie beschrieben, den Block 48.

In einem Schritt 50 fügt dann der Wandler 32 an die gebildeten zusammenhängenden Blöcke die dazugehörigen Header 14 inklusive der zugehörigen Seiteninformationen 16 an, um schließlich MP3-Kanalelemente 52a, 52b und 52c zu bilden. Jedes MP3-Kanalelement 52a-c besteht somit aus dem Header 14 eines korrespondierenden MP3-Datenblocks, einem sich daran anschließenden Seiteninformationsteil 16 desselben MP3-Datenblocks und dem zusammenhängenden Block 48 von Hauptdaten, die die Zeitmarke codieren, der der Datenblock zugeordnet ist, aus dem Header und Seiteninformationen stammen.

Die sich auf die Schritte 42 und 50 ergebenden MP3-Kanalelemente besitzen zueinander unterschiedliche Kanalelementlängen, wie sie durch Doppelpfeile 54a-54c angezeigt sind. Es sei daran erinnert, daß die Datenblöcke 10a, 10b in dem MP3-Audiodatenstrom 10 zwar eine feste Framelänge 56 besäßen, aufgrund der Bitsparkassenfunktion allerdings die Anzahl an Hauptdaten zu den einzelnen Zeitmarken um einen Mittelwert schwankt.

Um nun eine Decodierung und insbesondere ein Parsen bzw. syntaktisches Analysieren der einzelnen MP3-Kanalelemente 52a-52c auf Decodiererseite zu erleichtern, werden die Header 14 H1-H3 modifiziert, um die Länge des jeweiligen Kanalelements 52a-52c zu enthalten, d.h. 54a-54c. Dies wird in einem Schritt 56 durchgeführt. Die Längeneingabe wird dabei in einen für alle Header 14 des Audiodatenstroms 10 identischen bzw. redundanten Teil geschrieben. Beim MP3-Format enthält jeder Header beispielsweise gleich zu Beginn ein festes Synchronisationswort (syncword) bestehend aus 12 Bit. In Schritt 56 wird dieses Synchronisationswort durch die Länge des jeweiligen Kanalelements besetzt. Die 12 Bits des Synchronisationswortes reichen aus, um die Länge des jeweiligen Kanalelements in binärer Form darzustellen, so daß die Länge der entstehenden MP3-Kanalelemente 58a-58c mit modifiziertem Header h1-h3 trotz Schritt 56 gleich bleibt, d.h. gleich 54a-54c ist. Auf diese Weise können die Audioinformationen nach Aneinanderreihung der MP3-Kanalelemente 58a-58c gemäß der Reihenfolge der durch sie codierten Zeitmarken trotz Hinzufügung der Längenangabe auch mit der gleichen Bitrate in Echtzeit übertragen und abgespielt werden wie der ursprüngliche MP3-Audiodatenstrom 10, solange kein weiterer Overhead durch zusätzliche Header hinzukommt.

In einem Schritt 58 wird dann noch ein Datei-Header, oder für den Fall, dass es sich bei dem zu erzeugenden Datenstrom nicht um eine Datei handelt sondern Streaming vorliegt, ein Datenstrom-Header, für den erwünschten MPEG-4-Audiodatenstrom erstellt (Schritt 60). Da nach dem vorliegenden Ausführungsbeispiel ein MPEG-4-konformer Audiodatenstrom erzeugt werden soll, wird der Datei- bzw. File-Header gemäß dem MPEG-4-Standard erzeugt, wobei der Datei-Header im Aufbau in diesem Fall durch die Funktion AudioSpecificConfig festgelegt ist, die im oben genannten MPEG-4-Standard definiert ist. Die Schnittstelle zu dem MPEG-4-System wird durch das Element ObjectTypeIndication geliefert, das mit dem Wert 0x40 gesetzt wird, sowie durch die Angabe eines audioObjectTypes mit der Nummer 29. Die MPEG-4-spezifische AudioSpecificConfig wird entsprechend ihrer ursprünglichen Definition in ISO/IEC 14496-3 wie folgt erweitert, wobei im folgenden Beispiel nur die für die vorliegende Beschreibung wesentlichen Inhalte der AudioSpecificConfig aber nicht alle berücksichtigt sind:

```
1 AudioSpecificConfig() {
2 audioObjectType;
3 samplingFrequencyIndex;
4 if (samplingFrequencyIndex==0xf)
5 samplingFrequency;
6 channelConfiguration;
7 if (audioObjectType==29) {
8 MPEG_1_2_SpecificConfig();
9 }
10 }
```

Die obige Auflistung der AudiospecificConfig ist eine Darstellung in üblicher Schreibweise für die Funktion AudioSpecificConfig, die im Decodierer zum Parsen bzw. Lesen der Aufrufparameter in dem Datei-Header dient, nämlich des samplingFrequencyIndex (Abtastfrequenzindex), der channelConfiguration (Kanalkonfiguration) und dem audioObjectType (Audioobjekttyp) ausgeführt wird, bzw. die Anweisungen angibt, wie der Datei-Header zu decodieren bzw. syntaktisch zu analysieren ist.

Wie es zu erkennen ist, beginnt der Datei-Header, der in Schritt 60 erzeugt wird, mit der Angabe des audioObjectTypes, der wie im vorhergehenden erwähnt, auf 29 gesetzt wird (Zeile 2). Der Parameter audioObjectType gibt dem Decodierer an, auf welche Weise die Daten codiert worden sind, und insbesondere auf welche Weise weitere Informationen zur Codierung dem Datei-Header im folgenden entnommen werden können, wie es noch beschrieben werden wird.

Daraufhin folgt der Aufrufparameter samplingFrequencyIndex, der auf eine bestimmte Stelle in einer normierten Tabelle für Abtastfrequenzen zeigt (Zeile 3). Ist der Index 0 (Zeile 4) erfolgt die Angabe der Abtastfrequenz daraufhin ohne Verweis auf eine normierte Tabelle (Zeile 5).

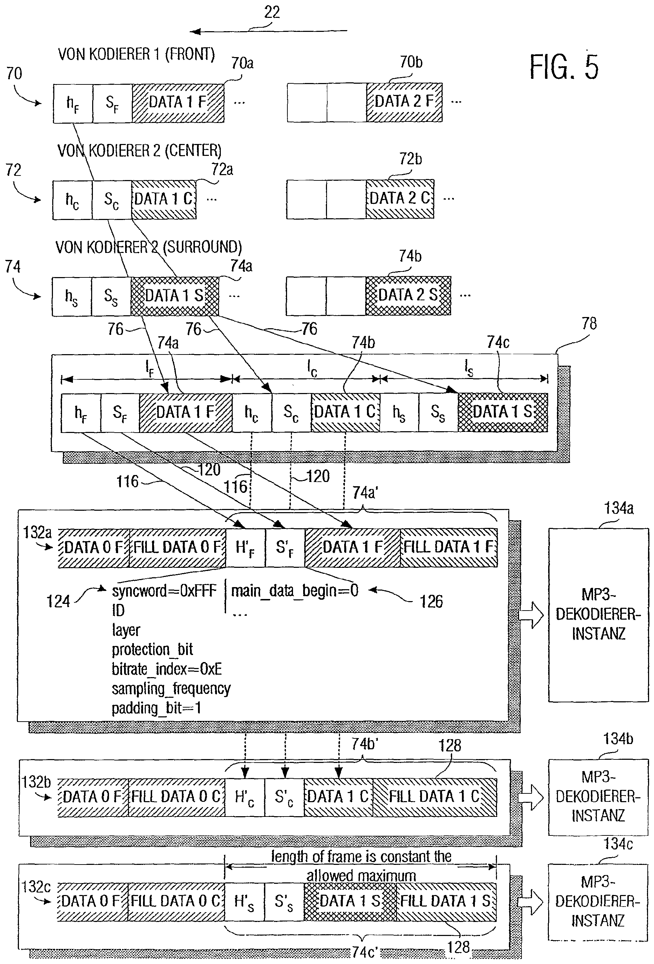

Daraufhin folgt die Angabe einer Kanalkonfiguration (Zeile 6), die auf eine noch im folgenden näher erörterte Weise angibt, wie viele Kanäle in dem erzeugten MPEG-4-Audiodatenstrom enthalten sind, wobei anders als in dem vorliegenden Ausführungsbeispiel es auch möglich ist, mehr als einen MP3-Audiodatenstrom zu einem MPEG-4-Audiodatenstrom zu vereinen, wie es später noch Bezug nehmend auf Fig. 5 beschrieben werden wird.

Danach folgt, falls der audioObjectType 29 ist, was vorliegend ja der Fall ist, ein Teil in dem Datei-Header AudioSpecificConfig, der einen redundanten Teil der MP3-Frame-Header in dem Audiodatenstrom 10 enthält, d.h. denjenigen Teil, der unter den Frame-Headern 14 gleich bleibt (Zeile 8). Dieser Teil ist vorliegend mit MPEG_1_2_SpecificConfig() bezeichnet, wiederum eine Funktion, die den Aufbau dieses Teils definiert.

Obwohl der Aufbau der MPEG_1_2_SpecificConfig auch dem MP3-Standard entnommen werden kann, da er ja dem festen Teil eines MP3-Frameheaders entspricht, der sich von Frame zu Frame nicht ändert, wird im folgenden exemplarisch der Aufbau derselben aufgelistet:

```
1 MPEG_1_2_SpecificConfig(channelConfiguration) {
2 syncword
3 ID
4 layer
5 reserved
6 sampling_frequency
7 reserved
8 reserved
9 reserved
10 if (channelConfiguration==0) {
11 Kanalkonfigurationsbeschreibung;
12 }
13 }
```

In dem Teil MPEG_1_2_SpecificConfig werden alle Bits, die sich von Frame-Header zu Frame-Header 14 in dem MP3-Audiodatenstrom unterscheiden, 0 gesetzt. Für jeden Frame-Header auf jeden Fall gleich ist der erste Parameter in der MPEG_1_2_SpecificConfig, nämlich das 12-Bit-Synchronisationswort syncword, das der Einsynchronisation eines MP3-Codierers bei Empfang eines MP3-Audiodatenstroms dient (Zeile 2). Der nachfolgende Parameter ID (Zeile 3) gibt die MPEG-Version, d.h. 1 oder 2, mit dem korrespondierenden Standard ISO/IEC 13818-3 für die Version 2 und mit dem Standard ISO/IEC 11172-3 für die Version 1 an. Der Parameter layer (Schicht) (Zeile 4) gibt den Hinweis auf layer 3, was dem MP3-Standard entspricht. Das folgende Bit ist reserviert ("reserved" in Zeile 5), da sich dessen Wert von Frame zu Frame ändern kann und von den MP3-Kanalelementen übertragen wird. Diese Bit zeigt gegebenenfalls an, daß der Header von einer CRC-Variablen gefolgt wird. Die nächste Variable sampling_frequency (Zeile 6) verweist auf eine Tabelle mit Abtastraten die im MP3-Standard definiert sind und gibt dadurch die Abtastrate an, die den MP3-DCT-Koeffizienten zugrundeliegt. Danach erfolgt in Zeile 7 wiederum die Angabe eines Bits für spezifische Anwendungen (reserved) ebenso wie in Zeilen 8 und 9. Dann erfolgt (in Zeile 11, 12) die genaue Definition der Kanalkonfiguration, wenn der in Zeile 6 der AudioSpecificConfig angegebene Parameter nicht auf eine vordefinierte Kanalkonfiguration hinweist sondern den Wert 0 aufweist. Ansonsten gilt die Kanalkonfiguration aus 14496-3 subpart 1 Tabelle 1.11.

Durch den Schritt 60 und insbesondere durch das Vorsehen des Elements MPEG_1_2_SpecificConfig in dem Datei-Header, welches alle redundanten Angaben in den Frame-Headern 14 des ursprünglichen MP3-Audiodatenstroms 10 enthält, wird gewährleistet, daß dieser redundante Teil in den Frame-Headern bei Einfügung von die Decodierung erleichternden Daten, wie z.B. im Schritt 56 durch die Einfügung der Kanalelementlänge, nicht zu einem unwiederbringlichen Verlust dieser Informationen in der zu erzeugenden MPEG-4-Datei führt, sondern dieser modifizierte Teil anhand des MPEG-4-Datei-Headers wieder rekonstruiert werden kann.

In Schritt 62 wird daraufhin der MPEG-4-Audiodatenstrom in der Reihenfolge des in Schritt 60 erzeugten MPEG-4-Dateiheaders und der Kanalelemente in der Reihenfolge ihrer zugeordneten Zeitmarken ausgegeben, wobei der vollständige MPEG-4-Audiodatenstrom dann eine MPEG-4-Datei ergibt, oder durch MPEG4-Systeme übertragen wird.

Die vorhergehende Beschreibung bezog sich auf die Umwandlung eines MP3-Audiodatenstroms in einen MPEG-4-Audiodatenstrom. Wie es jedoch mit gepunkteten Linien in Fig. 2 ersichtlich ist, ist es ebenfalls möglich, zwei oder mehrere MP3-Audiodatenströme von zwei MP3-Codierern, nämlich 30 und 30', zu einem MPEG-4-Mehrkanalaudiodatenstrom umzuwandeln. In diesem Fall erhält der MP3-MPEG-4-Wandler 32 die MP3-Audiodatenströme aller Codierer 30 und 30' und gibt den Mehrkanalaudiodatenstrom im MPEG-4-Format aus.

Fig. 5 stellt in der oberen Hälfte in Anlehnung an die Darstellung von Fig. 4 dar, auf welche Weise der Mehrkanalaudiodatenstrom nach MPEG-4 erzielt werden kann, wobei die Umwandlung wieder durch den Wandler 32 durchgeführt wird. Dargestellt sind drei Kanalelementfolgen 70, 72 und 74, die gemäß den Schritten 40-56 aus jeweils einem Audiosignal durch einen MP3-Codierer 30 bzw. 30' (Fig. 2) erzeugt worden sind. Aus jeder Folge von Kanalelementen 70, 72 und 74 sind jeweils zwei Kanalelemente gezeigt, nämlich 70a, 70b, 72a, 72b bzw. 74a, 74b. In Fig. 5 sind die übereinander angeordneten Kanalelemente, hier 70a-74a bzw. 70b-74b, jeweils der gleichen Zeitmarke zugeordnet. Die Kanalelemente der Folge 70 codieren beispielsweise das Audiosignal, welches gemäß einer geeigneten Normierung vorn links, rechts (front) aufgenommen worden ist, während die Folgen 72 und 84 Audiosignale codieren, die eine Aufnahme der gleichen Audioquelle von anderen Richtungen oder mit anderem Frequenzspektrum darstellen, wie z.B. dem zentralen Frontlautsprecher (center) und von hinten rechts und links (surround).

Wie mit Pfeilen 76 angedeutet, werden diese Kanalelemente nun während der Ausgabe (vgl. Schritt 62 in Fig.

3) in den MPEG-4-Audiodatenstrom zu Einheiten aneinandergehängt, im folgenden als access-unit bzw. Zugriffseinheiten 78 bezeichnet. Die Daten innerhalb einer access-unit 78 beziehen sich folglich im MPEG-4-Audiodatenstrom immer auf eine Zeitmarke. Die Anordnung der MP3-Kanalelemente 70a, 72a und 74a innerhalb der access-unit 78, hier in der Reihenfolge front-, center- und surround-Kanal, wird im Datei-Header, wie er für den zu erzeugenden MPEG-4-Audiodatenstrom erzeugt wird (vgl. Schritt 60 in Fig. 3) durch entsprechende Einstellung des Rufparameters Kanalkonfiguration in der AudioSpecificConfig berücksichtigt, wobei hierzu auf den subpart 1 in ISO/IEC 14496-3 verwiesen wird. Die Access-units 78 werden dann im MPEG-4-Strom wiederum der Reihenfolge der Zeitmarken nach hintereinander angeordnet und es ist ihnen der MPEG-4-Dateiheader vorangestellt. In dem MPEG-4-Dateiheader wird der Parameter channelConfiguration geeignet eingestellt, um die Reihenfolge der Kanalelemente in den access-units bzw. ihre Bedeutung auf Dekodiererseite anzuzeigen.

Wie die vorhergehende Beschreibung von Fig. 5 gezeigt hat, ist es sehr einfach, MP3-Audiodatenströme zu einem Mehrkanalaudiodatenstrom zusammenzufassen, wenn, wie gemäß der vorliegenden Erfindung vorgeschlagen, die MP3-Audiodatenströme manipuliert werden, um in sich abgeschlossene Kanalelemente aus den Datenblöcken zu erhalten, bei denen alle Daten zu einer Zeitmarke in einem Kanalelement enthalten sind, wobei diese Kanalelemente der einzelnen Kanäle dann auf einfache Weise zu access-units zusammengefaßt werden können.

Die vorhergehende Beschreibung bezog sich auf die Umwandlung von einem oder mehreren MP3-Audiodatenströmen in einen MPEG-4-Audiodatenstrom. Eine wesentliche Erkenntnis der vorliegenden Erfindung beruht aber auch darauf, daß all die Vorteile des entstehenden MPEG-4-Audiodatenstroms, wie die bessere Handhabbarkeit der einzelnen in sich abgeschlossenen MP3-Kanalelemente bei gleicher Übertragungsrate und die Möglichkeit der Mehrkanalübertragung, genutzt werden können, ohne existierende MP3-Decodierer vollständig durch neue Dekodierer ersetzen zu müssen, sondern daß die Rekonvertierung bzw. Rückumwandlung ebenfalls unproblematisch durchgeführt werden kann, so daß bei der Dekodierung des vorbeschriebenen MPEG-4-Audiodatenstroms diese genutzt werden können.

In Fig. 6 ist dies in einer Anordnung eines MP3-Rekonstruierers 100, dessen Funktionsweise im folgenden noch näher erläutert werden wird, und von MP3-Decodierern 102, 102' ... verdeutlicht. Ein MP3-Rekonstruierer 100 empfängt an einem Eingang einen MPEG-4-Audiodatenstrom, wie er nach einem der vorhergehenden Ausführungsbeispiele erzeugt worden ist, und gibt einen, oder in dem Fall des Mehrkanalaudiodatenstroms mehrere MP3-Audiodatenströme an einen bzw. mehrere MP3-Decodierer 102, 102' ... aus, welche ihrerseits wiederum den jeweils empfangenen MP3-Audiodatenstrom zu einem jeweiligen Audiosignal decodieren und beispielsweise an entsprechende Lautsprecher entsprechende Lautsprecher weitergeben, die gemäß der Kanalkonfiguration angeordnet sind.

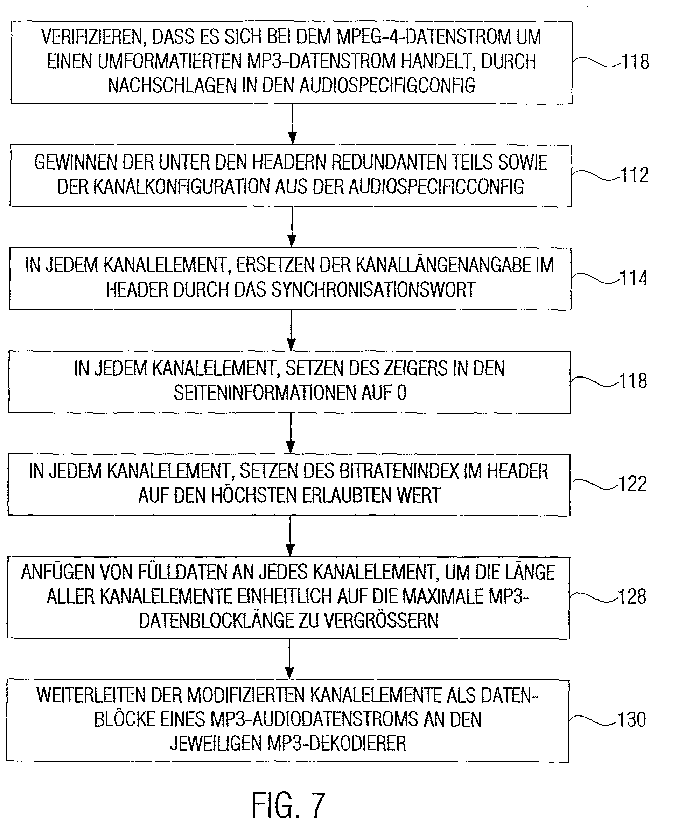

Eine besonders einfache Art und Weise der Rekonstruktion der ursprünglichen MP3-Audiodatenströme eines nach Fig. 5 erzeugten MPEG-4-Mehrkanalaudiodatenstroms wird Bezug nehmend auf Fig. 5 unten und Fig. 7 beschrieben, wobei diese Schritte durch den MP3-Rekonstruierer 100 von Fig. 6 durchgeführt werden.

Zunächst verifiziert der MP3-Rekonstruierer 100 in einem Schritt 110, daß es sich bei dem am Eingang empfangenen MPEG-4-Audiodatenstrom um einen umformatierten MP3-Audiodatenstrom handelt, indem derselbe gemäß der AudioSpecificConfig den Aufrufparameter audioObjectType in dem Datei-Header daraufhin überprüft, ob derselbe den Wert 29 enthält. Ist dies der Fall (Zeile 7 in der AudioSpecificConfig) geht der MP3-Rekonstruierer 100 in seiner syntaktischen Analyse des Datei-Headers des MPEG-4-Audiodatenstroms weiter und liest aus dem Teil-MPEG_1_2_SpecificConfig den redundanten Teil aller Frame-Header des ursprünglichen MP3-Audiodatenstroms, aus dem der MPEG-4-Audiodatenstrom erhalten worden ist (Schritt 112).

Nach der Evaluierung der MPEG_1_2_SpecificConfig ersetzt in einem Schritt 114 daraufhin der MP3-Rekonstruierer 100 in jedem Kanalelement 74a-74c in dem dortigen Header $h_F$, $h_c$, $h_s$ ein oder mehrere Teile der Kanalelemente durch Bestandteile der MPEG_1_2_SpecificConfig, insbesondere die Kanalelementlängenangabe durch das Synchronisationswort aus der MPEG_1_2_SpecificConfig, um wieder die ursprüngliche MP3-Audiodatenstrom-Frame-Header $H_F$, $H_C$ und $H_S$ zu erhalten, wie es durch Pfeile 116 angezeigt ist. In einem Schritt 118 modifiziert daraufhin der MP3-Rekonstruierer 100 in dem MPEG-4-Audiodatenstrom in jedem Kanalelement die Seiteninformationen $S_f$, $S_c$ und $S_s$. Insbesondere wird nämlich der Rückwärtszeiger bzw. Backpointer auf 0 gesetzt um neue Seiteninformationen $S'_F$, $S'_C$ und $S'_S$ zu erhalten. Die Manipulation nach Schritt 118 ist in Fig. 5 durch Pfeile 120 angedeutet. In einem Schritt 122 setzt daraufhin der MP3-Rekonstruierer 100 in jedem Kanalelement 74a-74c den Bitratenindex im gemäß Schritt 114 mit dem Synchronisationswort anstatt der Kanalelementlängenangabe versehenen Frame-Header $H_F$, $H_C$, $H_S$ auf den höchsten erlaubten Wert ein. Im Endeffekt weichen folglich die sich ergebenden Header von den ursprünglichen ab, was in Fig. 5 durch einen Apostroph angedeutet ist, d.h. $H'_F$, $H'_C$ und $H'_S$. Die Manipulation der Kanalelemente nach Schritt 122 ist ebenfalls durch den Pfeil 116 angedeutet.

Um die Änderungen der Schritte 114-122 nochmal zu veranschaulichen, sind in Fig. 5 für den Header $H'_F$ und den Seitenindexteil $S'_F$ einzelne Parameter darunter aufgelistet. Bei 124 sind einzelne Parameter des Headers $H'_F$ angezeigt. Der Frame-Header $H'_F$ beginnt mit dem Parameter syncword. Syncword ist auf den ursprünglichen Wert eingestellt (Schritt 114), wie es in jedem MP3-Audiodatenstrom der Fall ist, nämlich auf den Wert 0xFFF. Überhaupt unterscheidet sich ein Frame-Header $H'_F$, wie er nach den Schritten 114-122 entsteht, lediglich dadurch von dem ursprünglichen MP3-Frame-Header, wie er in dem ursprünglichen MP3-Audiodatenstrom 10 enthalten war, daß der Bitratenindex auf den höchsten erlaubten Wert eingestellt ist, was nach dem MP3-Standard OxE ist.

Sinn und Zweck der Änderung des Bitratenindex besteht darin, für den neu zu erzeugenden MP3-Audiodatenstrom eine neue Framelänge bzw. Datenblocklänge zu erzielen, die größer ist als die des ursprünglichen MP3-Audiodatenstroms, aus welchem der MPEG-4-Audiodatenstrom mit access-unit 78 erzeugt worden ist. Der Trick besteht hier darin, daß die Framelänge in Bytes im MP3-Format stets von der Bitrate abhängt, und zwar nach der Formel:

Für MPEG 1 layer 3:

$$\text{Framelänge[Bit]} = 1152*\text{Bitrate[Bit/s]}/\text{Abtastrate[Bit/s]} + {} + 8*\text{paddingbit[Bit]}$$

Für MPEG 2 layer 3:

$$\text{Framelänge[Bit]} = 576*\text{Bitrate[Bit/s]}/\text{Abtastrate[Bit/s]} + {} + 8*\text{paddingbit[Bit]}$$

Anders ausgedrückt, ist die Framelänge eines MP3-Audiodatenstroms gemäß dem Standard direkt proportional zur Bitrate und indirekt proportional zur Abtastrate. Als additiver Wert kommt noch der Wert des Paddingbits hinzu, der in den MP3-Frame-Headern $h_F$, $h_C$, $h_S$ angegeben ist und verwendet werden kann, um die Bitrate exakt einzustellen. Die Abtastrate ist fest, da sie bestimmt, mit welcher Geschwindigkeit das dekodierte Audiosignal abgespielt wird. Die Umstellung der Bitrate im Vergleich zur ursprünglichen Einstellung ermöglicht es nun, auch solche MP3-Kanalelemente 74a-74c in einer Datenblocklänge des neu zu erzeugenden MP3-Audiodatenstroms unterzubringen, die länger sind als die ursprüngliche, da zur Erzeugung des ursprünglichen Audiodatenstroms die Hauptdaten unter Entnahme von Bits aus der Bitsparkasse entstanden sind.

Obwohl im vorliegenden Ausführungsbeispiel folglich der Bitratenindex immer auf den höchst erlaubten Wert eingestellt wird, wäre es ferner möglich, den Bitratenindex nur auf einen Wert zu erhöhen, der ausreicht, um eine Datenblocklänge gemäß dem MP3-Standard zu ergeben, so daß auch die längsten MP3-Kanalelemente 74a-74c von der Länge her hineinpassen.

Bei 126 ist dargestellt, daß der Rückwärtszeiger main_data_begin in den entstehenden Seiteninformationen auf 0 gesetzt ist. Dies bedeutet nichts anderes, als daß in dem nach dem Verfahren von Fig. 7 erzeugten MP3-Audiodatenstrom die Datenblöcke immer in sich abgeschlossen sind, so daß die Hauptdaten zu einem bestimmten Frame-Header und den Seiteninformationen immer direkt im Anschluß an die Seiteninformationen beginnen und noch innerhalb desselben Datenblocks enden.

Die Schritte 114, 118, 122 werden an jedem Kanalelement durchgeführt, indem dieselben jeweils aus ihrer access-unit extrahiert werden, wobei die Kanalelementlängenangaben bei der Extraktion nützlich sind.

In einem Schritt 128 werden daraufhin an jedes Kanalelement 74a-74c so viele Fülldaten bzw. don't-care-Bits angehängt, um die Länge aller MP3-Kanalelemente einheitlich auf die MP3-Datenblocklänge zu vergrößern, wie sie durch den neuen Bitratenindex 0xE festgelegt ist. Diese Fülldaten sind in Fig. 5 bei 128 angezeigt. Die Menge an Fülldaten kann für jedes Kanalelement beispielsweise durch Auswertung der Kanalelementlängenangabe und des Paddingbits berechnet werden.

In einem Schritt 130 werden daraufhin die nach den vorhergehenden Schritten modifizierten Kanalelemente, in Fig. 5 bei 74a'-74c' gezeigt, als Datenblöcke eines MP3-Audiodatenstroms in der Reihenfolge der codierten Zeitmarken an einen jeweiligen MP3-Decodierer bzw. eine MP3-Decodiererinstanz 134a-134c weitergeleitet. Der MPEG-4-Datei-Header wird weggelassen. Die sich ergebenden MP3-Audiodatenströme sind in Fig. 5 allgemein mit 132a, 132b und 132c angezeigt. Die MP3-Decodierer-Instanzen 134a-134c sind beispielsweise bereits zuvor initialisiert worden, und zwar so viele wie Kanalelemente in den einzelnen Access units enthalten sind.

Der MP3-Rekonstruierer 100 weiß, welche Kanalelemente 74a-74c in einer access-unit 78 des MPEG-4-Audiodatenstroms zu welchem der zu erzeugenden MP3-Audiodatenströme 132a-132c gehört, aus einer Auswertung des Aufrufparameters channelConfiguration in der AudioSpecificConfig des MPEG-4-Audiodatenstroms. Die MP3-Decodierer-Instanz 134a, die mit dem Front-Lautsprecher verbunden ist, erhält demnach den Audiodatenstrom 132a, der dem Front-Kanal entspricht, und dementsprechend erhalten die MP3-Decodiererinstanzen 134b und 134c die Audiodatenströme 132b und 132c, die dem center- und surround-Kanal zugeordnet sind, und geben die hieraus entstehenden Audiosignale an entsprechend angeordnete Lautsprecher weiter nämlich beispielsweise an einen subwoover bzw. hinten links und hinten rechts angeordnete Lautsprecher.

Freilich ist es für eine Echtzeitdecodierung des MPEG-4-Audiodatenstroms durch die Anordnung von Fig. 6 mit den Decodiererinstanzen 102, 102' bzw. 134a-134c notwendig, daß die neu erzeugten MP3-Audiodatenströme 132a-132c mit der in Schritt 122 erhöhten Bitrate weitergeleitet werden, die höher ist als dies beim ursprünglichen MP3-Audiodatenstrom 10 der Fall war, was jedoch kein Problem darstellt, da ja die Anordnung zwischen MP3-Rekonstruierer 100 und den MP3-Decodierern 102, 102' bzw. 134a-134c fest ist, so daß hier die Übertragungsstrecken entsprechend kurz und mit entsprechend hoher Datenrate unter geringen Kosten und Aufwand ausgelegt werden können.

Gemäß dem Bezug nehmend auf Fig. 7 beschriebenen Ausführungsbeispiel, wurde ein nach Fig. 5 aus ursprünglichen MP3-Audiodatenströmen 10 erhaltener MPEG-4-Mehrkanalaudiodatenstrom nicht zu exakt den ursprünglichen MP3-Audiodatenströmen rückkonvertiert sondern es wurden aus demselben andere MP3-Audiodatenströme erzeugt, bei denen im Unterschied zu den ursprünglichen Audiodatenströmen alle Rückwärtszeiger auf 0 gesetzt und der Bitratenindex auf den höchsten Wert eingestellt ist. Die Datenblöcke dieser neu entstandenen MP3-Audiodatenströme sind folglich ebenfalls in sich abgeschlossen insofern, als alle Daten, die einer bestimmten Zeitmarke zugeordnet sind, in ein und demselben Datenblock 74'a-74'c enthalten sind, und Fülldaten verwendet worden sind, um die Datenblocklänge auf einen einheitlichen Wert zu verlängern.

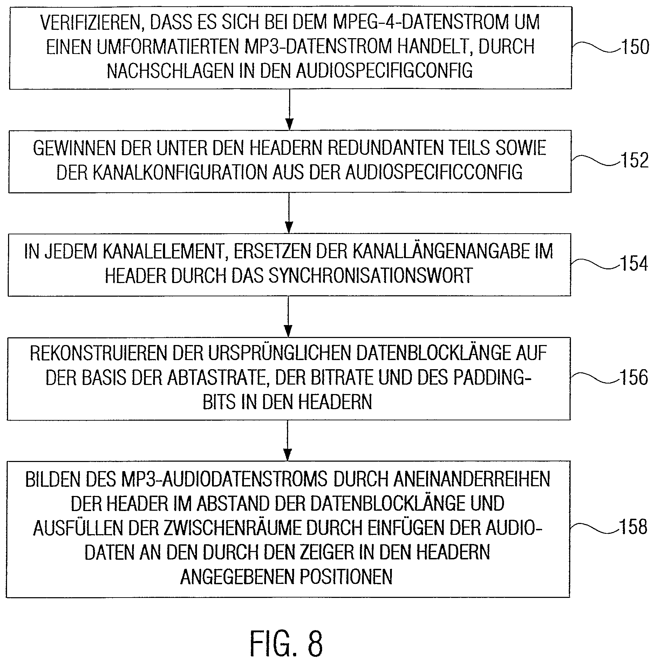

Fig. 8 zeigt nun ein Ausführungsbeispiel für ein Verfahren, nach dem es möglich ist, eine nach den Ausführungsbeispielen von Fig. 1-5 entstandenen MPEG-4-Audiodatenstrom wieder in die ursprünglichen MP3-Audioströme bzw. den ursprünglichen MP3-Audiodatenstrom rückzukonvertieren.

In diesem Fall prüft der MP3-Rekonstruierer 100 wieder in einem Schritt 150 genau wie in Schritt 110, ob es sich bei dem MPEG-4-Audiodatenstrom um einen umformatierten MP3-Audiodatenstrom handelt. Auch die nachfolgenden Schritte 152 und 154 entsprechen den Schritten 112 und 114 der Vorgehensweise von Fig. 7.

Anstatt jedoch die Rückwärtszeiger in den Seiteninformationen und die Bitratenindex in den Frame-Headern zu ändern, rekonstruiert der MP3-Rekonstruierer 100 nach dem Verfahren von Fig. 8 in einem Schritt 156 daraufhin die ursprüngliche Datenblocklänge in den ursprünglichen MP3-Audiodatenströmen, die zu dem MPEG-4-Audiodatenstrom konvertiert wurden, auf der Basis der Abtastrate, der Bitrate und des padding-Bits. Die Abtastrate und die Paddingangabe sind in der MPEG_1_2_SpecificConfig und die Bitrate in jedem Kanalelement angegeben, wenn sich letztere von Frame zu Frame unterscheidet.

Die Formel zur Berechnung der ursprünglichen Framelänge des ursprünglichen und zu rekonstruierenden MP3-Audiodatenstroms lautet wiederum wie im vorhergehenden bereits erwähnt:

Für MPEG 1 layer 3:

$$\text{Framelänge[Bit]} = 1152 * \text{Bitrate[Bit/s]} / \text{Abtastrate[Bit/s]} + {} + 8 * \text{paddingbit[Bit]}$$

Für MPEG 2 layer 3:

$$\text{Framelänge[Bit]} = 576 * \text{Bitrate[Bit/s]} / \text{Abtastrate[Bit/s]} + {} + 8 * \text{paddingbit[Bit]}$$

Daraufhin werden dann der MP3-Audiodatenstrom bzw. die MP3-Audiodatenströme dadurch erzeugt, daß die jeweiligen Frame-Header aus dem jeweiligen Kanal im Abstand der berechneten Datenblocklänge angeordnet werden und die Zwischenräume durch Einfügen der Audiodaten bzw. Hauptdaten an den durch den Zeigern in den Seiteninformationen angegebenen Positionen aufgefüllt werden. Anders als bei dem Ausführungsbeispiel von Fig. 7 bzw. 5 werden hier also die zu dem jeweiligen Header bzw. der jeweiligen Seiteninformation zugehörigen Hauptdaten mit Beginn an der durch den Rückwärtszeiger angegebenen Stelle in den MP3-Audiodatenstrom eingesetzt. Oder anders ausgedrückt, wird der Anfang der dynamischen Hauptdaten entsprechend dem Wert von main_data_begin versetzt. Der MPEG-4-Datei-Header wird weggelassen. Der so entstehende MP3-Audiodatenstrom bzw. die so entstehenden MP3-Audiodatenströme entsprechen den ursprünglichen MP3-Audiodatenströmen, wie sie dem MPEG-4-Audiodatenstrom zugrunde lagen. Auch diese MP3-Audiodatenströme könnten also, wie die Audiodatenströme von Fig. 7 auch, durch herkömmliche MP3-Decodierer zu Audiosignalen decodiert werden.

In Bezug auf die vorhergehende Beschreibung wird darauf hingewiesen, daß an manchen Stellen die als Einkanal-MP3-Audiodatenströme beschriebenen MP3-Audiodatenströme in Wirklichkeit bereits Zweikanal-MP3-Audiodatenströme waren, die nach dem ISO/IEC-Standard 13818-3 definiert waren, wobei hier jedoch in der Beschreibung nicht näher darauf eingegangen worden ist, da sich hieraus nichts für das Verständnis der vorliegenden Erfindung ändert. Matrizierungsoperationen aus den übertragenen Kanälen zur Rückgewinnung der Eingangskanäle auf Decodiererseite und die Verwendung mehrerer Backpointer bei diesen Mehrkanalsignalen sind deshalb nicht erläutert worden, sondern es wird auf den entsprechenden Standard verwiesen.

Die vorhergehenden Ausführungsbeispiele ermöglichten es MP3-Datenblöcke in veränderter Form im MPEG-4-Dateiformat zu speichern. MPEG-1/2-Audio-Layer-3, kurz MP3, oder daraus abgeleitete proprietäre Formate wie MPEG2.5 oder mp3PRO können auf der Basis dieser Vorgehensweisen in eine MPEG-4-Datei verpackt werden, so daß diese neue Darstellung eine Multikanaldarstellung beliebig vieler Kanäle auf einfache Weise repräsentiert. Eine Verwendung des komplizierten und wenig verbreiteten Verfahrens aus dem Standard ISO/IEC 13818-3 ist nicht notwendig. Insbesondere werden die MP3-Datenblöcke so gepackt, daß jeder Block - Kanalelement oder access-unit - zu einer definierten Zeitmarke gehört.

Bei den vorhergehenden Ausführungsbeispielen zum Ändern des Formats der digitalen Signaldarstellung wurden Teile der Darstellung mit anderen Daten überschrieben. Anders ausgedrückt, werden für den Decoder notwendige oder nützliche Informationen über den für verschiedene Blöcke innerhalb eines Datenstroms konstanten Teil des MP3-Datenblocks geschrieben.

Durch das Packen mehrere Mono- oder Stereodatenblöcke in ein access-unit des MPEG-4-Dateiformats konnte auch eine Multikanaldarstellung erhalten werden, die gegenüber der Darstellung aus Standard ISO/IEC-13818-3 wesentlich einfacher zu handhaben ist.

Bei den vorhergehenden Ausführungsbeispielen wurde die Darstellung eines MP3-Datenblocks so verändert formatiert, daß alle Daten, die zu einer bestimmten Zeitmarke gehören, auch innerhalb einer access unit enthalten sind. Das ist im allgemeinen bei MP3-Datenblöcken nicht der Fall, da das Element main_data_begin bzw. der Rückwärtszeiger im originalen MP3-Datenblock auf zeitlich zurückliegende Datenblöcke verweisen kann.

Die Rekonstruktion des ursprünglichen Datenstroms konnte ebenfalls durchgeführt werden (Fig. 8). Das bedeutete, wie gezeigt, daß die wiederhergestellten Datenströme von jedem konformen Decoder verarbeitet werden könnten.

Darüber hinaus erlaubten es obige Ausführungsbeispiele mehr als zwei Kanäle zu en- und decodieren. Ferner müssen bei obigen Ausführungsbeispielen die fertig codierten MP3-Daten nur durch einfache Operationen umformatiert werden, um ein Multikanalformat zu erhalten. Auf der anderen Seite mußten auf Codiererseite nur diese Operation bzw. diese Operationen rückgängig gemacht werden.

Während also ein MP3-Datenstrom normalerweise Datenblöcke ungleicher Länge enthält, da die dynamischen Daten, die zu einem Block gehören in vorherigen Blöcken gepackt sein können, bündelten die vorhergehenden Ausführungsbeispiele die dynamischen Daten direkt hinter die Seiteninformationen. Der resultierende MPEG-4-Datenstrom hatte dann eine konstante mittlere Bitrate, aber Datenblöcke von unterschiedlicher Länge. Das Element main_data_begin bzw. der Rückwärtszeiger wird unverändert mit übertragen, um eine Wiederherstellung des originalen Datenstroms zu gewährleisten.

Ferner wurde Bezug nehmend auf Fig. 5 eine Erweiterung der MPEG-4-Syntax beschrieben, um mehrere MP3-Datenblöcke als MP3-Kanalelemente zu einem Multikanalformat innerhalb einer MPEG-4-Datei zu verpacken. Alle MP3-Kanalelement-Einträge, die zu einem Zeitpunkt gehören, wurden in einer access unit verpackt. Dem MPEG-4-Standard entsprechend können die codiererseitig geeigneten Informationen zur Konfiguration aus der sogenannten AudioSpecificConfig entnommen werden. Diese enthält neben dem audioObjectType, der Abtastrate und Kanalkonfiguration usw. einen Deskriptor, der für den jeweiligen audioObjectType relevant ist. Dieser Deskriptor wurde im vorhergehenden bezüglich der MPEG_1_2_SpecificConfig beschrieben.

Nach den vorhergehenden Ausführungsbeispielen wurde das 12-Bit-MPEG-1/2-syncword im Header durch die Länge des jeweiligen MP3-Kanalelements ersetzt. Nach ISO/IEC-13818-3 sind hierfür 12 Bit ausreichend. Der verbleibende Header wurde nicht weiter modifiziert, was jedoch freilich geschehen kann, um beispielsweise die Frame-Header und den restlichen redundanten Teil außer dem syncword zu verkürzen, um somit die Menge an zu übertragenden Informationen zu reduzieren.

Verschiedene Variationen können an obigen Ausführungsbeispielen ohne weiteres vorgenommen werden. So ist die Reihenfolge in den Schritten in den Fig. 3, 7, 8 abänderbar, insbesondere der Schritte 42, 50, 56, 60 in Fig. 3, 11, 114, 118, 122 und 128 in Fig. 7 und 152, 154, 156 in Fig. 8.

Bezüglich der Fig. 3, 7, 8 wird ferner darauf hingewiesen, daß die dort gezeigten Schritte durch entsprechende Merkmale in dem Wandler bzw. Rekonstruierer der Fig. 2 bzw. 6 durchgeführt werden, die beispielsweise als ein Computer oder eine festverdrahtete Schaltung ausgeführt sein können.

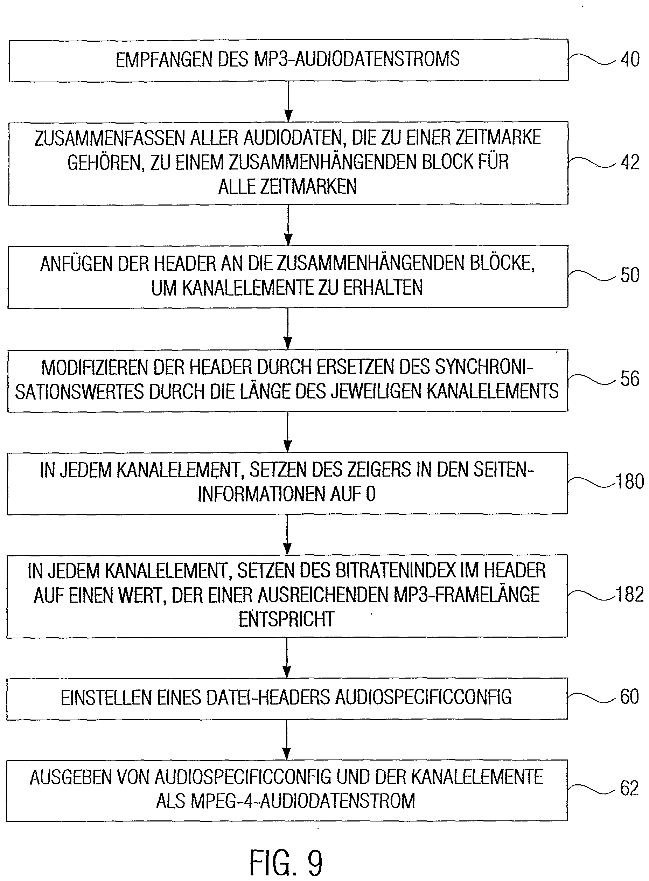

Bei dem Ausführungsbeispiel von Fig. 7 fand die Manipulation der Header bzw. Seiteninformationen (Schritte (118, 122) zu dem zum ursprünglichen MP3-Datenstrom leicht veränderten MP3-Datenstrom für die MP3-Dekodierer auf Empfänger- bzw. Dekodiererseite statt. In vielen Anwendungsfällen kann es vorteilhaft sein, diese Schritte auf Encoder- bzw. Senderseite durchzuführen, da die Empfängergeräte meist Massenartikel sind, so dass Einsparungen in der Elektronik auf Empfängerseite deutlich höhere Gewinne ermöglichen. Gemäß einem alternativen Ausführungsbeispiel kann es deshalb vorgesehen sein, dass diese Schritte bereits bei der MP3-MPEG4-Datenformatumwandlung durchgeführt werden. Die Schritte nach diesem alternativen Formatumwandlungsverfahren sind in Fig. 9 gezeigt, wobei Schritte, die zu denen in Fig. 3 identisch sind, mit gleichen Bezugszeichen versehen wurden, und auch nicht noch einmal beschrieben werden, um Wiederholungen zu vermeiden.

Zunächst wird der umzuwandelnde MP3-Audiodatenstrom in Schritt 40 empfangen und in Schritt 42 die Audiodaten, die zu einer Zeitmarke gehören, bzw. eine Codierung eines Zeitabschnitts des durch den MP3-Audiodatenstrom codierten Audiosignals darstellen, der zu der jeweiligen Zeitmarke gehört, zu einem zusammenhängenden Block zusammengefasst, und zwar für alle Zeitmarken. Die Header werden wieder an die zusammenhängenden Blöcke angefügt, um die Kanalelemente zu erhalten (Schritt 50). Allerdings werden die Header nicht nur, wie in Schritt 56, durch Ersetzen des Synchronisationswortes durch die Länge des jeweiligen Kanalelements modifiziert. Vielmehr erfolgen in den Schritten 118 und 122 von Fig. 7 entsprechenden Schritten 180 und 182 weitere Modifikationen. Und zwar wird in Schritt 180 die der Zeiger in den Seiteninformationen jedes Kanalelements auf Null gesetzt, und in Schritt 182 wird der Bitratenindex in dem Header jedes Kanalelements so verändert, dass die, wie im vorhergehenden beschrieben, von der Bitrate abhängige MP3-Datenblocklänge ausreicht, um alle Audiodaten dieses Kanalelements bzw. der zugehörigen Zeitmarke zusammen mit der Größe des Headers und den Seiteninformationen zu umfassen. Der Schritt 182 umfasst gegebenenfalls ferner das Umstellen der Paddingbits in den Headern der aufeinanderfolgenden Kanalelemente, um später, bei Zuführung des durch das Verfahren von Fig. 9 gebildeten MPEG-4.Audiodatenstroms zu einem nach dem Verfahren von Fig. 7 aber ohne die Schritte 118 und 122 arbeitenden Dekodierer, zu einer genauen Bitrate zu führen. Das Padding kann natürlich auch auf Dekodiererseite im Rahmen von Schritt 128 durchgeführt werden.

Bei Schritt 182 kann es sich lohnen, den Bitratenindex nicht auf den höchst möglichen Wert einzustellen, wie es bezugnehmend auch Schritt 122 beschrieben wurde. Der Wert kann auch auf den minimalen Wert eingestellt werden, der ausreicht, um alle Audiodaten, den Header und die Seiteninformationen eines Kanalelements in einer berechneten MP3-Framelänge aufzunehmen, was auch bedeuten kann, dass in dem Fall kurzer, mit geringer Menge an Koeffizienten codierbarer Passagen des codierten Audiostückes der Bitratenindex verringert wird.

Nach diesen Modifikationen wird in den Schritten 60 und 62 lediglich noch der Datei-Header (AudioSpecificConfig) erzeugt und derselbe zusammen mit den M3-Kanalelementen als MPEG-4-Audiodatenstrom ausgegeben. Dieser kann, wie bereits erwähnt, nach dem verfahren von Fig. 7 abgespielt werden, wobei jedoch die Schritte 118 und 122 fahlen können, was die Implementierung auf Dekoderseite erleichtert. Die Schritte 42, 50, 56, 180, 182 und 60 können freilich in beliebiger Reihenfolge durchgeführt werden.

Vorhergehende Beschreibung bezog sich lediglich exemplarisch auf MP3-Datenströme mit fester Datenblockbitlänge. Freilich können auch MP3-Datenströme mit variabler Datenblocklänge gemäß den vorhergehenden Ausführungsbeispielen verarbeitet werden, bei denen sich der Bitratenindex und damit ja auch die Datenblocklänge von Frame zu Frame ändert.

Vorhergehende Beschreibung bezog sich auf MP3-Audiodatenströme. Bei anderen, nicht zeigerbasierten Audiodatenströmen sieht ein Ausführungsbeispiel der vorliegenden Erfindung das Modifizieren der Header in den Datenblöcken von exemplarisch eines MPEG ½ layer 2 Audiodatenstromes vor, die neben den Headern noch die zugehörigen Seiteninformationen und die zugehörigen Audiodaten enthalten und folglich bereits in sich abgeschlossen sind, um einen MPEG-4-Audiodatenstrom zu erzeugen. Die Modifikation versieht jeden Header mit einer Längenangabe, die die Datenmenge von entweder dem jeweiligen Datenblock oder den Audiodaten in dem jeweiligen Datenblock angibt, damit der MPEG-4-Datenstrom leichter zu dekodieren ist, insbesondere wenn derselbe aus mehreren MPEG 1/2 layer 2 Audiodatenströmen zu einem Mehrkanalaudiodatenstrom zusammengesetzt wird, ähnlich der vorhergehenden Beschreibung bezugnehmend auf Fig. 5. Die Modifikation wird vorzugsweise ähnlich auf die im vorhergehenden beschriebene Weise durch Ersetzung der Syncwörter oder eines anderen redundanten Teils derselben in den Headern des MPEG 1/2 layer 2 Datenstromes durch die Längenangaben erzielt. Die der Fig. 5 bereits vorangegangene Zeigerumformatierung bzw. -auflösung durch Zusammenfassen der zu einer Zeitmarke gehörenden Audiodaten entfällt bei layer 2 Datenströmen, da dort keine Backpointer existieren. Die Dekodierung eines aus zwei MEPG 1/2 layer Audiodatenströmen, die zwei Kanäle eines Mehrkanalaudiodatenstromes darstellen, zusammengesetzten MPEG-4-Audiodatenströmes ist einfach, indem die Längenangaben ausgelesen wird und auf der Basis derselben schnell auf die einzelnen Kanalelemente in den Zugriffeinheiten zugegriffen wird. Diese können dann an herkömmliche MPEG 1/2 layer 2 konforme Dekodierer weitergeleitet werden.

Ferner ist es für die vorliegende Erfindung nicht wesentlich, wo sich genau der Rückwärtszeiger in den Datenblöcken des zeigerbasierten Audiodatenstroms befindet. Er könnte sich ferner unmittelbar in den Frame-Headern befinden, um mit demselben einen zusammenhängenden Bestimmungsblock zu definieren.

Insbesondere wird darauf hingewiesen, daß abhängig von den Gegebenheiten das erfindungsgemäße Schema zur Dateiformatumwandlung auch in Software implementiert sein kann. Die Implementation kann auf einem digitalen Speichermedium, insbesondere einer Diskette oder einer CD mit elektronisch auslesbaren Steuersignalen erfolgen, die so mit einem programmierbaren Computersystem zusammenwirken können, daß das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

**Patentansprüche**

1.  Verfahren zum Umwandeln eines ersten Audiodatenstroms, der ein codiertes Audiosignal, das Zeitabschnitte umfasst, darstellt und ein erstes Dateiformat hat, in einen zweiten Audiodatenstrom, der das codierte Audiosignal darstellt und ein zweites Dateiformat hat, wobei ein Zeitabschnitt eine Anzahl von Audiowerten umfasst, und wobei gemäß dem ersten Dateiformat der erste Audiodatenstrom in aufeinanderfolgende Datenblöcke gegliedert ist, wobei ein Datenblock einen Header und Datenblockaudiodaten aufweist, wobei alle Header einen für alle Header identischen, redundanten Teil aufweisen, mit folgendem Schritt:

    Modifizieren der Datenblöcke, damit dieselben eine Längenangabe enthalten, die die Datenmenge der Datenblöcke oder eine Datenmenge der Datenblockaudiodaten angibt, um aus den Datenblöcken Kanalelemente zu erhalten, die den zweiten Audiodatenstrom bilden, wobei der Schritt des Modifizierens das Ersetzen des für alle Header identischen, redundanten Teils durch die Längenangabe aufweist,
    wobei das Verfahren ferner ein Voranstellen (60, 62) eines Gesamtheaders an den zweiten Audiodatenstrom aufweist, und der Gesamtheader den für alle Header identischen, redundanten Teil aufweist, oder der für alle Header identische, redundante Teil ein Synchronisationswort ist.

2.  Verfahren gemäß Anspruch 1, wobei dem Header (14, 16) Headeraudiodaten zugeordnet sind, die durch Codierung eines Zeitabschnitts erhalten werden, wobei der Header einen Zeiger enthält, der auf einen Anfang der Headeraudiodaten (12a-12c) zeigt, und wobei ein Ende der Headeraudiodaten (12a-12c) vor einem Anfang von Headeraudiodaten (12b,12c) in dem Audiodatenstrom liegt, die einem nächsten Datenblock zugeordnet sind, mit folgenden Schritten:

    Zusammenfassen (42) der Headeraudiodaten (44,46), die einem Header zugeordnet sind, aus zumindest zwei Datenblöcken, um zusammenhängende Headeraudiodaten (48) zu erhalten, die Teil des zweiten Audiodatenstroms bilden;
    Anfügen (50) der zusammenhängenden Headeraudiodaten (48) an den Header (14, 16), dem die Headeraudiodaten (44,46) zugeordnet sind, aus den die zusammenhängenden Headeraudiodaten erhalten werden, um ein Kanalelement (52a) zu erhalten;
    Anordnen der Kanalelemente, um den zweiten Audiodatenstrom zu erhalten; und
    Modifizieren (56) des Kanalelements (54a-54c), damit dasselbe eine Längenangabe enthält, die die Datenmenge des Kanalelements (54a-54c) oder eine Datenmenge der zusammenhängenden Headeraudiodaten angibt, wobei der Schritt des Modifizierens das Ersetzen (56) eines für alle Header identischen, redundanten Teils durch die Längenangabe aufweist.

3.  Verfahren gemäß Anspruch 1 oder 2, bei dem der Schritt des Zusammenfassens folgende Teilschritte aufweist:

    Lesen des Zeigers in einem Header;
    Lesen eines ersten Teils der Headeraudiodaten, der in Datenblockaudiodaten eines der zumindest zwei Datenblöcke enthalten ist und den Anfang der Headeraudiodaten umfasst, auf den der Zeiger des Headers zeigt;
    Lesen eines zweiten Teils der Headeraudiodaten, der in Datenblockaudiodaten des anderen der zumindest zwei Datenblöcke enthalten ist und das Ende der Headeraudiodaten umfasst; und
    Zusammenfügen des ersten und zweiten Teils.

4.  Verfahren zum Zusammenfassen eines ersten Audiodatenstroms, der ein codiertes erstes Audiosignal darstellt, und eines zweiten Audiodatenstroms, der ein codiertes zweites Audiosignal darstellt, zu einem Mehrkanal-Audiodatenstrom, mit folgenden Schritten:

    Umwandeln des ersten Audiodatenstroms in einen ersten Teilaudiodatenstrom nach dem Verfahren nach einem der Ansprüche 1 bis 3; und
    Umwandeln des zweiten Audiodatenstroms in einen zweiten Teilaudiodatenstrom nach dem Verfahren nach einem der Ansprüche 1 bis 3, wobei die Schritte des Anordnens so durchgeführt werden, daß die beiden Teilaudiodatenströme zusammen den Mehrkanalaudiodatenstrom bilden, und daß in dem Mehrkanalaudiodatenstrom jeweils die Kanalelemente (70a) des ersten Teilaudiodatenstroms und die Kanalelemente (72a) des zweiten Teilaudiodatenstroms, die zusammenhängende Headeraudiodaten enthalten, die durch Codierung von zeitgleichen Zeitabschnitten erhalten werden, in einer zusammenhängenden Zugriffseinheit (78) hintereinander angeordnet sind.

5. Verfahren gemäß Anspruch 4, das ferner folgenden Schritt aufweist:

Voranstellen eines Gesamtheaders an den zweiten Audiodatenstrom, wobei der Gesamtheader eine Formatangabe enthält, die angibt, in welcher Reihenfolge die Kanalelemente (70a) des ersten Teilaudiodatenstroms und des zweiten Teilaudiodatenstroms (70b) in den Zugriffseinheiten (78) angeordnet sind.

6. Verfahren gemäß einem der vorhergehenden Ansprüche, bei dem die Datenblöcke Datenblöcke gleicher oder einer vorbestimmten variabler Größe sind, die von einer Abtastratenangabe und einer Bitratenangabe in dem Header derselben abhängt.

7. Verfahren gemäß einem der Ansprüche 1 bis 3, das ferner folgende Schritte aufweist:

Rücksetzen (180) der Zeiger in den Headern, so dass dieselben als einen Anfang der Headeraudiodaten angeben, daß die Headeraudiodaten unmittelbar im Anschluß an den jeweiligen Header beginnen; und
Verändern (182) der Bitratenangaben in den Headern, so dass eine von den Bitratenangaben abhängige Datenblocklänge gemäß dem ersten Audiodateiformat ausreicht, um den jeweiligen Header und die zugehörigen Headeraudiodaten aufzunehmen.

8. Verfahren zum Decodieren eines zweiten Audiodatenstroms, der ein codiertes Audiosignal, das Zeitabschnitte umfasst, darstellt und ein zweites Dateiformat hat, auf der Basis eines Decodierers, der in der Lage ist einen ersten Audiodatenstrom, der das codierte Audiosignal darstellt und ein erstes Dateiformat hat, zu einem Audiosignal zu decodieren, wobei ein Zeitabschnitt eine Anzahl von Audiowerten umfasst, und wobei gemäß dem ersten Dateiformat der erste Audiodatenstrom mit Bitsparkassenfunktion in aufeinanderfolgende Datenblöcke (10a-10c) gegliedert ist, wobei ein Datenblock einen Header (14, 16) und Datenblockaudiodaten (18) aufweist, wobei dem Header (14, 16) Headeraudiodaten zugeordnet sind, die durch Codierung eines Zeitabschnitts erhalten werden, wobei der Header einen Zeiger enthält, der auf einen Anfang der Headeraudiodaten (12a-12c) zeigt, und wobei ein Ende der Headeraudiodaten (12a-12c) vor einem Anfang von Headeraudiodaten (12b,12c) in dem Audiodatenstrom liegt, die einem nächsten Datenblock zugeordnet sind, und wobei gemäß dem zweiten Dateiformat der zweite Audiodatenstrom in Kanalelemente gegliedert ist, wobei ein Kanalelement zusammenhängende Headeraudiodaten (44,46), die durch Zusammenfassen von Headeraudiodaten, die einem Header zugeordnet sind, aus zwei Datenblöcken erhalten werden, und den zugeordneten Header in einer Form umfassen, in der ein für alle Header identischer, vormals redundanter Teil modifiziert ist, um durch eine Längenangabe ersetzt zu sein, die die Datenmenge des jeweiligen Kanalelements oder eine Datenmenge der jeweiligen zusammenhängenden Headerdaten angibt, wobei dem zweiten Audiodatenstrom ein Gesamtheader vorangestellt ist, der einen für alle Header identischen, redundanten Teil aufweist, mit folgenden Schritten:

Bilden eines Eingangsdatenstroms, das das codierte Audiosignal darstellt und ein erstes Dateiformat aufweist, aus dem zweiten Audiodatenstrom durch

Verifizieren, dass es sich bei dem zweiten Audiodatenstrom um einen aus dem ersten Dateiformat umformatierten Datenstrom handelt;
Lesen des identischen, vormals redundanten Teils aus dem Gesamtheader;
Ersetzen der Längenangabe in den Headern durch den identischen, vormals redundanten Teil;
Rücksetzen der Zeiger in den Headern der Kanalelemente des zweiten Audiodatenstroms, so daß dieselben als einen Anfang der Headeraudiodaten angeben, daß die Headeraudiodaten unmittelbar im Anschluß an den jeweiligen Header beginnen, um rückgesetzte Header zu erhalten;
Verändern einer Bitratenangabe in den Headern der Kanalelemente des zweiten Audiodatenstroms, so dass eine von der Bitratenangabe abhängige Datenblocklänge gemäß dem ersten Audiodateiformat in allen Headern ausreicht, um den jeweiligen Header und die zugehörigen Headeraudiodaten aufzunehmen, um bitratenveränderte und rückgesetzte Header zu erhalten; und
Einfügen von Bits zwischen jedem Kanalelement und dem nachfolgenden Kanalelement, so daß die Länge jedes Kanalelements plus der eingefügten Bits an die veränderte Bitratenangabe angepasst ist, und

Zuführen des Eingangsdatenstroms an den Decodierer gemäß der veränderten Bitratenangabe, um das Audiosignal zu erhalten.

**EP 1 647 010 B1**

9. Vorrichtung zum Umwandeln eines ersten Audiodatenstroms, der ein codiertes Audiosignal, das Zeitabschnitte umfasst, darstellt und ein erstes Dateiformat hat, in einen zweiten Audiodatenstrom, der das codierte Audiosignal darstellt und ein zweites Dateiformat hat, wobei ein Zeitabschnitt eine Anzahl von Audiowerten umfasst, und wobei gemäß dem ersten Dateiformat der erste Audiodatenstrom in aufeinanderfolgende Datenblöcke gegliedert ist, wobei ein Datenblock einen Header und Datenblockaudiodaten aufweist, wobei alle Header einen für alle Header identischen, redundanten Teil aufweisen, mit folgenden Merkmal:

einer Einrichtung zum Modifizieren der Datenblöcke, damit dieselben eine Längenangabe enthalten, die die Datenmenge der Datenblöcke oder eine Datenmenge der Datenblockaudiodaten angibt, um aus den Datenblöcken Kanalelemente zu erhalten, die den zweiten Audiodatenstrom bilden, wobei der Schritt des Modifizierens das Ersetzen eines für alle Header identischen, redundanten Teils durch die Längenangabe aufweist, wobei die Vorrichtung ferner eine Einrichtung zum Voranstellen (60, 62) eines Gesamtheaders an den zweiten Audiodatenstrom aufweist, und der Gesamtheader den für alle Header identischen, redundanten Teil aufweist, oder wobei der für alle Header identische, redundante Teil ein Synchronisationswort ist.

10. Vorrichtung gemäß Anspruch 9, wobei dem Header (14, 16) Headeraudiodaten zugeordnet sind, die durch Codierung eines Zeitabschnitts erhalten werden, wobei der Header einen Zeiger enthält, der auf einen Anfang der Headeraudiodaten (12a-12c) zeigt, und wobei ein Ende der Headeraudiodaten (12a-12c) vor einem Anfang von Headeraudiodaten (12b,12c) in dem Audiodatenstrom liegt, die einem nächsten Datenblock zugeordnet sind, mit folgenden Merkmalen:

einer Einrichtung zum Zusammenfassen (42) der Headeraudiodaten (44,46), die einem Header zugeordnet sind, aus zwei Datenblöcken, um zusammenhängende Headeraudiodaten (48) zu erhalten, die Teil des zweiten Audiodatenstroms bilden;
einer Einrichtung zum Anfügen (50) der zusammenhängenden Headeraudiodaten (48) an den Header (14, 16), dem die Headeraudiodaten (44,46) zugeordnet sind, aus die die zusammenhängenden Headeraudiodaten erhalten werden, um ein Kanalelement (52a) zu erhalten; und
eine Einrichtung zum Anordnen der Kanalelemente, um den zweiten Audiodatenstrom zu erhalten; und
einer Einrichtung zum Modifizieren (56) des Kanalelements (54a-54c), damit dasselbe eine Längenangabe enthält, die die Datenmenge des Kanalelements (54a-54c) oder eine Datenmenge der zusammenhängenden Headeraudiodaten angibt, wobei die Einrichtung zum Modifizieren (56) ausgebildet ist, um einen für alle Header identischen, redundanten Teils durch die Längenangabe zu ersetzen.

11. Vorrichtung zum Decodieren eines zweiten Audiodatenstroms, der ein codiertes Audiosignal, das Zeitabschnitte umfasst, darstellt und ein zweites Dateiformat hat, auf der Basis eines Decodierers, der in der Lage ist einen ersten Audiodatenstrom, der das codierte Audiosignal darstellt und ein erstes Dateiformat hat, zu einem Audiosignal zu decodieren, wobei ein Zeitabschnitt eine Anzahl von Audiowerten umfasst, und wobei gemäß dem ersten Dateiformat der erste Audiodatenstrom mit Bitsparkassenfunktion in aufeinanderfolgende Datenblöcke (10a-10c) gegliedert ist, wobei ein Datenblock einen Header (14, 16) und Datenblockaudiodaten (18) aufweist, wobei dem Header (14, 16) Headeraudiodaten zugeordnet sind, die durch Codierung eines Zeitabschnitts erhalten werden, wobei der Header einen Zeiger enthält, der auf einen Anfang der Headeraudiodaten (12a-12c) zeigt, und wobei ein Ende der Headeraudiodaten (12a-12c) vor einem Anfang von Headeraudiodaten (12b,12c) in dem Audiodatenstrom liegt, die einem nächsten Datenblock zugeordnet sind, und wobei gemäß dem zweiten Dateiformat der zweite Audiodatenstrom in Kanalelemente gegliedert ist, wobei ein Kanalelement zusammenhängende Headeraudiodaten (44,46), die durch Zusammenfassen con Headeraudiodaten, die einem Header zugeordnet sind, aus zwei Datenblöcken erhalten werden, und den zugeordneten Header in einer Form umfassen, in der ein für alle Header identischer, vormals redundanter Teil modifiziert ist, um durch eine Längenangabe ersetzt zu sein, die die Datenmenge des jeweiligen Kanalelements oder eine Datenmenge der jeweiligen zusammenhängenden Headerdaten angibt, wobei dem zweiten Audiodatenstrom ein Gesamtheader vorangestellt ist, der einen für alle Header identischen, redundanten Teil aufweist, mit folgenden Merkmalen:

einer Einrichtung zum Bilden eines Eingangsdatenstroms, das das codierte Audiosignal darstellt und ein erstes Dateiformat aufweist, aus dem zweiten Audiodatenstrom durch

Verifizieren, dass es sich bei dem zweiten Audiodatenstrom um einen aus dem ersten Dateiformat umformatierten Datenstrom handelt;
Lesen des identischen, vormals redundanten Teils aus dem Gesamtheader;
Ersetzen der Längenangabe in den Headern durch den identischen, vormals redundanten Teil;

Rücksetzen der Zeiger in den Headern der Kanalelemente des zweiten Audiodatenstroms, so dass dieselben als einen Anfang der Headeraudiodaten angeben, dass die Headeraudiodaten unmittelbar im Anschluss an den jeweiligen Header beginnen, um rückgesetzte Header zu erhalten;

Verändern einer Bitratenangabe in den Headern der Kanalelemente des zweiten Audiodatenstroms, so dass eine von der Bitratenangabe abhängige Datenblocklänge gemäß dem ersten Audiodateiformat in allen Headern ausreicht, um den jeweiligen Header und die zugehörigen Headeraudiodaten aufzunehmen, um bitratenveränderte und rückgesetzte Header zu erhalten; und

Einfügen von Bits zwischen jedem Kanalelement und dem nachfolgenden Kanalelement, so dass die Länge jedes Kanalelements plus der eingefügten Bits an die veränderte Bitratenangabe angepasst ist, und

einer Einrichtung zum Zuführen des Eingangsdatenstroms an den Decodierer gemäß der veränderten Bitratenangabe, um das Audiosignal zu erhalten.

**12.** Vorrichtung gemäß Anspruch 11, wobei der für alle Header identische, redundante Teil ein Synchronisationswort ist.

**13.** Vorrichtung gemäß Anspruch 11 oder 12, wobei die Einrichtung zum Bilden des Eingangsdatenstroms ausgebildet ist, bei der Veränderung der Bitratenangabe selbige auf einen höchsten erlaubten Wert einzustellen.

**14.** Computer-Programm mit einem Programmcode zur Durchführung des Verfahrens nach einem der Ansprüche 1 oder 8, wenn das Computer-Programm auf einem Computer abläuft.

**Claims**

**1.** A method for converting a first audio data stream representing a coded audio signal comprising time periods and having a first file format into a second audio data stream representing the coded audio signal and having a second file format, wherein a time period comprises a number of audio values, and wherein, according to the first file format, the first audio data stream is divided into subsequent data blocks, wherein a data block comprises a header and data block audio data, wherein all the headers comprise a redundant part identical for all the headers, comprising:

modifying the data blocks so that the same include a length indication indicating the amount of data of the data blocks or an amount of data of the data block audio data to obtain channel elements forming the second audio data stream from the data blocks, wherein the step of modifying includes replacing the redundant part identical for all the headers by the length indication,

wherein the method further comprises placing (60, 62) an overall header in front of the second audio data stream and the overall header has the redundant part identical for all the headers, or the redundant part identical for all the headers is a synchronization word.

**2.** The method according to claim 1, wherein header audio data are associated to the header (14, 16), which are obtained by coding a time period, wherein the header comprises a pointer pointing to a beginning of the header audio data (12a-12c), and wherein an end of the header audio data (12a-12c) lies prior to a beginning of header audio data (12b, 12c) in the audio data stream associated to a next data block, comprising the steps of:

combining (42) the header audio data (44, 46) associated to a header of at least two data blocks to obtain contiguous header audio data (48) forming part of the second audio data stream;

adding (50) the header (14, 16) to which header audio data (44, 46) are associated, from which the contiguous header audio data are obtained, to the contiguous header audio data (48) to obtain a channel element (52a);

arranging the channel elements to obtain the second audio data stream; and

modifying (56) the channel element (54a-54c) so that the same includes a length indication indicating the amount of data of the channel element (54a-54c) or an amount of data of the contiguous header audio data, wherein the step of modifying comprises replacing (56) a redundant part identical for all the headers by the length indication.

**3.** The method according to claim 1 or 2, wherein the step of combining comprises the sub-steps of:

reading the pointer in a header;

reading a first part of the header audio data included in data block audio data of one of the at least two data blocks and comprising the beginning of the header audio data to which the pointer of the header points;

reading a second part of the header audio data included in data block audio data of the other of the at least two data blocks and comprising the end of the header audio data; and
combining the first and second parts.

4. A method for combining a first audio data stream representing a coded first audio signal and a second audio data stream representing a coded second audio signal into a multi-channel audio data stream, comprising the steps of:

converting the first audio data stream into a first sub-audio data stream according to the method of one of claims 1 to 3; and
converting the second audio data stream into a second sub-audio data stream according to the method of one of claims 1 to 3,
wherein the steps of arranging are performed such that the two sub-audio data streams together form the multi-channel audio data stream, and that in the multi-channel audio data stream the channel elements (70a) of the first sub-audio data stream and the channel elements (72a) of the second sub-audio data stream containing contiguous header audio data obtained by coding time periods equal in time are arranged successively in a contiguous access unit (78).

5. The method according to claim 4, further comprising the step of:

placing an overall header in front of the second audio data stream, the overall header including a format indication indicating in which order the channel elements (70a) of the first sub-audio data stream and the second sub-audio data stream (70b) are arranged in the access units (78).

6. The method according to any of the previous claims, wherein the data blocks are data blocks of equal or predetermined variable size depending on a sample rate indication and a bit rate indication in the header of the same.

7. The method according to any of claims 1 to 3, further comprising the steps of:

resetting (180) the pointers in the headers, so that the same indicate as a beginning of the header audio data that the header audio data begin immediately after the respective header; and
changing (182) the bit rate indications in the headers such that a data block length depending on the bit rate indications according to the first audio file format is sufficient to take up the respective header and the associated header audio data.

8. A method for decoding a second audio data stream representing a coded audio signal comprising time periods and having a second file format, based on a decoder, which is able to decode a first audio data stream representing the coded signal and having a first file format, into an audio signal, wherein a time period comprises a number of audio values, and wherein according to the first file format, the first audio data stream is divided into successive data blocks (10a-10c) with a bit reservoir function, wherein a data block has a header (14, 16) and data block audio data (18), wherein header audio data, which are obtained by coding a time period, are associated to the header (14, 16), wherein the header includes a pointer pointing to a beginning of the header audio data (12a-12c), and wherein an end of the header audio data (12a-12c) is prior to a beginning of header audio data (12a-12c) in the audio data stream associated to a next data block, and wherein the second audio data stream is divided into channel elements according to the second file format, wherein a channel element comprises contiguous header audio data (44, 46) obtained by combining header audio data associated to a header from two data blocks, and the associated header in a form in which a formerly redundant part identical for all the headers is modified so as to be replaced by a length indication indicating the amount of data of the respective channel element or an amount of data of the respective contiguous header data, wherein an overall header comprising a redundant part identical for all the headers is placed in front of the second audio data stream, comprising the steps of:

forming an input data stream representing the coded audio signal and having a first file format, from the second audio data stream by

verifying that the second audio data stream is a data stream reformatted from the first data format;
reading the identical, formerly redundant part from the overall header; replacing the length indication in the headers by the identical, formerly redundant part;
resetting the pointers in the headers of the channel elements of the second audio data stream, so that the same indicate as a beginning of the header audio data that the header audio data begin immediately after the respective header to obtain reset headers;

changing a bit rate indication in the headers of the channel elements of the second audio data stream such that a data block length depending on the bit rate indication according to the first audio file format in all the headers is sufficient to take up the respective header and the associated header audio data to obtain bit rate-changed and reset headers;

inserting bits between every channel element and the subsequent channel element, so that the length of every channel element plus the inserted bits is adapted to the changed bit rate indication, and

supplying the input data stream to the decoder according to the changed bit rate indication to obtain the audio signal.

9. An apparatus for converting a first audio data stream representing a coded audio signal comprising time periods and having a first file format, into a second audio data stream representing the coded audio signal and having a second file format, wherein a time period comprises a number of audio values, and wherein, according to the first file format, the first audio data stream is divided into subsequent data blocks, wherein a data block comprises a header and data block audio data, wherein all the headers comprise a redundant part identical for all the headers, comprising:

means for modifying the data blocks so that the same include a length indication indicating the amount of data of the data blocks or an amount of data of the data block audio data to obtain channel elements forming the second audio data stream from the data blocks, wherein the step of modifying includes replacing a redundant part identical for all the headers by the length indication,

wherein the apparatus further comprises means for placing (60, 62) an overall header in front of the second audio data stream and the overall header has the redundant part identical for all the headers, or the redundant part identical for all the headers is a synchronization word.

10. The apparatus according to claim 9, wherein header audio data are associated to the header (14, 16), which are obtained by coding a time period, wherein the header comprises a pointer pointing to a beginning of the header audio data (12a-12c), and wherein an end of the header audio data (12a-12c) lies prior to a beginning of header audio data (12b, 12c) in the audio data stream associated to a next data block, comprising:

means for combining (42) the header audio data (44, 46) associated to a header of at least two data blocks to obtain contiguous header audio data (48) forming part of the second audio data stream;

means for adding (50) the header (14, 16) to which header audio data (44, 46) are associated, from which the contiguous header audio data are obtained, to the contiguous header audio data (48) to obtain a channel element (52a); and

means for arranging the channel elements to obtain the second audio data stream; and

means for modifying (56) the channel element (54a-54c) so that the same includes a length indication indicating the amount of data of the channel element (54a-54c) or an amount of data of the contiguous header audio data, wherein the means for modifying (56) is configured to replace a redundant part identical for all the headers by the length indication.

11. An apparatus for decoding a second audio data stream representing a coded audio signal comprising time periods and having a second file format, based on a decoder, which is able to decode a first audio data stream representing the coded signal and having a first file format, into an audio signal, wherein a time period comprises a number of audio values, and wherein according to the first file format, the first audio data stream is divided into successive data blocks (10a-10c) with a bit reservoir function, wherein a data block has a header (14, 16) and data block audio data (18), wherein header audio data, which are obtained by coding a time period, are associated to the header (14, 16), wherein the header includes a pointer pointing to a beginning of the header audio data (12a-12c), and wherein an end of the header audio data (12a-12c) is prior to a beginning of header audio data (12a-12c) in the audio data stream associated to a next data block, and wherein the second audio data stream is divided into channel elements according to the second file format, wherein a channel element comprises contiguous header audio data (44, 46) obtained by combining header audio data associated to a header from two data blocks, and the associated header in a form in which a formerly redundant part identical for all the headers is modified so as to be replaced by a length indication indicating the amount of data of the respective channel element or an amount of data of the respective contiguous header data, wherein an overall header comprising a redundant part identical for all the headers is placed in front of the second audio data stream, comprising:

means for forming an input data stream representing the coded audio signal and having a first file format, from the second audio data stream by

verifying that the second audio data stream is a data stream reformatted from the first data format;
reading the identical, formerly redundant part from the overall header; replacing the length indication in the headers by the identical, formerly redundant part;
resetting the pointers in the headers of the channel elements of the second audio data stream, so that the same indicate as a beginning of the header audio data that the header audio data begin immediately after the respective header to obtain reset headers;
changing a bit rate indication in the headers of the channel elements of the second audio data stream such that a data block length depending on the bit rate indication according to the first audio file format in all the headers is sufficient to take up the respective header and the associated header audio data to obtain bit rate-changed and reset headers; and
inserting bits between every channel element and the subsequent channel element, so that the length of every channel element plus the inserted bits is adapted to the changed bit rate indication, and

means for supplying the input data stream to the decoder according to the changed bit rate indication to obtain the audio signal.

**12.** The apparatus according to claim 11, wherein the redundant part identical for all the headers is a synchronization word.

**13.** The apparatus according to claim 11 or 12, wherein the means for forming the input data stream is configured to, when changing the bit rate indication, set the same to a highest value allowed.

**14.** A computer program with a program code for performing the method according to one of claims 1 or 8 when the computer program runs on a computer.

**Revendications**

**1.** Procédé pour convertir un premier flux de données audio qui représente un signal audio codé qui comporte des segments temporels et qui présente un premier format de fichier en un deuxième flux de données audio qui représente le signal audio codé et qui présente un deuxième format de fichier, où un segment temporel comporte un nombre de valeurs audio, et où, selon le premier format de fichier, le premier flux de données audio est divisé en blocs de données successifs, un bloc de données présentant un en-tête et des données audio de bloc de données, où tous les en-têtes présentent une partie redondante identique pour tous les en-têtes, à l'étape suivante consistant à:

modifier les blocs de données de sorte qu'ils contiennent une indication de longueur qui indique la quantité de données des blocs de données ou une quantité de données des données audio de bloc de données, pour obtenir à partir des blocs de données des éléments de canal qui constituent le deuxième flux de données audio, où l'étape de modification présente le fait de remplacer la partie redondante identique pour tous les en-têtes par l'indication de longueur,
dans lequel le procédé présente par ailleurs le fait de placer (60, 62) un en-tête d'ensemble devant le deuxième flux de données audio, et l'en-tête d'ensemble présente la partie redondante identique pour tous les en-têtes, ou la partie redondante identique pour tous les en-têtes est un mot de synchronisation.

**2.** Procédé selon la revendication 1, dans lequel sont associées à l'en-tête (14, 16) des données audio d'en-tête qui sont obtenues par codage d'un segment temporel, dans lequel l'en-tête contient un pointeur qui pointe vers un début des données audio d'en-tête (12a à 12c), et dans lequel une fin des données audio d'en-tête (12a à 12c) se situe, dans le flux de données audio, avant un début de données audio d'en-tête (12b, 12c) qui sont associées à un bloc de données suivant, aux étapes suivantes consistant à:

assembler (42) les données audio d'en-tête (44, 46) qui sont associées à un en-tête d'au moins deux blocs de données, pour obtenir des données audio d'en-tête cohérentes (48) qui forment une partie du deuxième flux de données audio;
annexer (50) les données audio d'en-tête cohérentes (48) à l'en-tête (14, 16) auquel sont associées les données audio d'en-tête (44, 46) à partir desquelles sont obtenues les données audio d'en-tête cohérentes, pour obtenir un élément de canal (52a);

disposer les éléments de canal pour obtenir le deuxième flux de données audio; et

modifier (56) l'élément de canal (54a à 54c) de sorte qu'il contienne une indication de longueur qui indique la quantité de données de l'élément de canal (54a à 54c) ou une quantité de données des données audio d'en-tête cohérentes, où l'étape de modification présente le remplacement (56) d'une partie redondante identique pour tous les en-têtes par l'indication de longueur.

3. Procédé selon la revendication 1 ou 2, dans lequel l'étape d'assemblage présente les étapes partielles suivantes consistant à:

lire le pointeur dans un en-tête;

lire une première partie des données audio d'en-tête qui est contenue dans l'un des au moins deux blocs de données qui et comporte le début des données audio d'en-tête vers lequel pointe le pointeur de l'en-tête;

lire une deuxième partie de des données audio d'en-tête qui est contenue dans les données audio de bloc de données de l'autre des au moins deux blocs de données et qui comporte la fin des données audio d'en-tête; et

assembler la première et la deuxième partie.

4. Procédé pour assembler un premier flux de données audio qui représente un premier signal audio codé et un deuxième flux de données audio qui représente un deuxième signal audio codé pour obtenir un flux de données audio multicanal, aux étapes suivantes consistant à:

convertir le premier flux de données audio en un premier du flux de données audio partiel selon le procédé selon l'une des revendications 1 à 3; et

convertir le deuxième flux de données audio en un deuxième flux de données audio partiel selon le procédé selon l'une des revendications 1 à 3,

dans lequel les étapes de disposition sont réalisées de sorte que les deux flux de données audio partiels forment ensemble le flux de données audio multicanal, et que dans le flux de données audio multicanal soient disposés l'un derrière l'autre dans une unité d'accès cohérente (78) respectivement les éléments de canal (70a) du premier flux de données audio partiel et les éléments de canal (72a) du deuxième flux de données audio partiel qui contiennent ensemble des données audio d'en-tête qui sont obtenues par codage de segments temporels simultanés.

5. Procédé selon la revendication 4, présentant par ailleurs l'étape suivante consistant à:

placer un en-tête d'ensemble devant le deuxième flux de données audio, où l'en-tête d'ensemble contient une indication de format qui indique l'ordre dans lequel les éléments de canal (70a) du premier flux de données audio partiel et du deuxième flux de données audio partiel (70b) sont disposés dans les unités d'accès (78).

6. Procédé selon l'une des revendications précédentes, dans lequel les blocs de données sont des blocs de données de même grandeur ou d'une grandeur variable prédéterminée qui dépend d'une indication de fréquence d'échantillonnage et d'une indication de débit binaire dans l'en-tête de ces derniers.

7. Procédé selon l'une des revendications 1 à 3, présentant par ailleurs les étapes suivantes consistant à:

réinitialiser (180) les pointeurs dans les en-têtes de sorte qu'ils indiquent comme début des données audio d'en-tête que les données audio d'en-tête commencent immédiatement à la suite de l'en-tête respectif; et

modifier (182) les indications de débit binaire dans les en-têtes de sorte qu'une longueur de bloc de données dépendant des indications de débit binaire selon le premier format de fichier audio soit suffisante pour recevoir l'en-tête respective et les données audio d'en-tête associées.

8. Procédé de décodage d'un deuxième flux de données audio qui représente un signal audio codé qui comporte des segments temporels et qui présente un deuxième format de fichier, sur base d'un décodeur qui est à même de décoder un premier flux de données audio qui représente le signal audio codé et qui présente un premier format de fichier, pour obtenir un signal audio, où un segment temporel comporte un nombre de valeurs audio, et dans lequel, selon le premier format de fichier, le premier flux de données audio à fonction de banque de bits est divisé en blocs de données successifs (10a à 10c), où un bloc de données présente un en-tête (14, 16) et des données audio de bloc de données (18), dans lequel sont associées à l'en-tête (14, 16) des données audio d'en-tête qui sont obtenues par codage d'un segment temporel, dans lequel l'en-tête contient un pointeur qui pointe vers un début des données audio d'en-tête (12a à 12c), et dans lequel une fin des données audio d'en-tête (12a à 12c) se situe, dans le flux de données audio, avant un début de données audio d'en-tête (12b, 12c) qui sont associées à un bloc de données suivant, et dans lequel, selon le deuxième format de fichier, le deuxième flux de données audio est divisé en éléments de canal, où un élément de canal comporte des données audio d'en-tête (44, 46) cohérentes qui sont obtenues de deux blocs de données en assemblant des données audio d'en-tête qui sont associées à un en-tête, et l'en-tête associé sous une forme dans laquelle une partie auparavant redondante identique pour tous les en-têtes est modifiée pour être remplacée par une indication de longueur qui indique la quantité de données de l'élément de canal respectif ou une quantité de données des données d'en-tête cohérentes respectives, dans lequel est placé devant le deuxième flux de données audio un en-tête d'ensemble qui présente une partie redondante identique pour tous les en-tête, aux étapes suivantes consistant à:

former un flux de données d'entrée qui représente le signal audio codé et qui présente un premier format de fichier, à partir du deuxième flux de données audio

en vérifiant qu'il s'agisse, pour le deuxième flux de données audio, d'un flux de données reformaté à partir du premier de format de fichier;
en lisant la partie auparavant redondante identique de l'en-tête d'ensemble;
en remplaçant l'indication de longueur dans les en-tête par la partie auparavant redondante identique;
en réinitialisant les pointeurs dans les en-têtes des éléments de canal du deuxième flux de données audio de sorte qu'ils indiquent comme début des données audio d'en-tête que les données audio d'en-tête commencent immédiatement à la suite de l'en-tête respectif, pour obtenir des en-têtes réinitialisés;
en modifiant une indication de débit binaire dans les en-têtes des éléments de canal du deuxième flux de données audio de sorte qu'une longueur de bloc de données dépendant de l'indication de débit binaire selon le premier format de fichier audio dans tous les en-têtes soit suffisante pour recevoir l'en-tête respectif et les données audio d'en-tête associées, pour obtenir des en-têtes à débit binaire modifié et réinitialisés; et
en insérant des bits entre chaque élément de canal et l'élément de canal suivant de sorte que la longueur de chaque élément de canal plus les bits insérés soit adaptée à l'indication de débit binaire modifié, et

alimenter le flux de données d'entrée vers le décodeur selon l'indication de débit binaire modifié, pour obtenir le signal audio.

**9.** Dispositif pour convertir un premier flux de données audio qui représente un signal audio codé qui comporte des segments temporels et qui présente un premier format de fichier en un deuxième flux de données audio qui représente le signal audio codé et qui présente un deuxième format de fichier, où un segment temporel comporte un nombre de valeurs audio, et où, selon le premier format de fichier, le premier flux de données audio est divisé en blocs de données successifs, un bloc de données présentant un en-tête et des données audio de bloc de données, où tous les en-têtes présentent une partie redondante identique pour tous les en-têtes, à la caractéristique suivante:

un moyen destiné à modifier les blocs de données de sorte qu'ils contiennent une indication de longueur qui indique la quantité de données des blocs de données ou une quantité de données des données audio de bloc de données, pour obtenir à partir des blocs de données des éléments de canal qui constituent le deuxième flux de données audio, où l'étape de modification présente le fait de remplacer une partie redondante identique pour tous les en-têtes par l'indication de longueur,
dans lequel le dispositif présente par ailleurs un moyen pour placer (60, 62) un en-tête d'ensemble devant le deuxième flux de données audio, et l'en-tête d'ensemble présente la partie redondante identique pour tous les en-têtes, ou la partie redondante identique pour tous les en-têtes est un mot de synchronisation.

**10.** Dispositif selon la revendication 9, dans lequel sont associées à l'en-tête (14, 16) des données audio d'en-tête qui sont obtenues par codage d'un segment temporel, dans lequel l'en-tête contient un pointeur qui pointe vers un début des données audio d'en-tête (12a à 12c), et dans lequel une fin des données audio d'en-tête (12a à 12c) se situe, dans le flux de données audio, avant un début de données audio d'en-tête (12b, 12c) qui sont associées à un bloc de données suivant, aux caractéristiques suivantes:

un moyen destiné à assembler (42) les données audio d'en-tête (44, 46) qui sont associées à un en-tête d'au moins deux blocs de données, pour obtenir des données audio d'en-tête cohérentes (48) qui forment une partie du deuxième flux de données audio;
un moyen destiné à annexer (50) les données audio d'en-tête cohérentes (48) à l'en-tête (14, 16) auquel sont associées les données audio d'en-tête (44, 46) à partir desquelles sont obtenues les données audio d'en-tête cohérentes, pour obtenir un élément de canal (52a);

un moyen destiné à disposer les éléments de canal pour obtenir le deuxième flux de données audio; et

un moyen destiné à modifier (56) l'élément de canal (54a à 54c) de sorte qu'il contienne une indication de longueur qui indique la quantité de données de l'élément de canal (54a à 54c) ou une quantité de données des données audio d'en-tête cohérentes, où un moyen destiné à modifier (56) est conçu pour remplacer une partie redondante identique pour tous les en-têtes par l'indication de longueur.

**11.** Dispositif de décodage d'un deuxième flux de données audio qui représente un signal audio codé qui comporte des segments temporels et qui présente un deuxième format de fichier, sur base d'un décodeur qui est à même de décoder un premier flux de données audio qui représente le signal audio codé et qui présente un premier format de fichier, pour obtenir un signal audio, où un segment temporel comporte un nombre de valeurs audio, et dans lequel, selon le premier format de fichier, le premier flux de données audio à fonction de banque de bits est divisé en blocs de données successifs (10a à 10c), où un bloc de données présente un en-tête (14, 16) et des données audio de bloc de données (18), dans lequel sont associées à l'en-tête (14, 16) des données audio d'en-tête qui sont obtenues par codage d'un segment temporel, dans lequel l'en-tête contient un pointeur qui pointe vers un début des données audio d'en-tête (12a à 12c), et dans lequel une fin des données audio d'en-tête (12a à 12c) se situe, dans le flux de données audio, avant un début de données audio d'en-tête (12b, 12c) qui sont associées à un bloc de données suivant, et dans lequel, selon le deuxième format de fichier, le deuxième flux de données audio est divisé en éléments de canal, où un élément de canal comporte des données audio d'en-tête (44, 46) associées qui sont obtenues de deux blocs de données en assemblant des données audio d'en-tête qui sont associées à un en-tête, et l'en-tête associé sous une forme dans laquelle une partie auparavant redondante identique pour tous les en-têtes est modifiée pour être remplacée par une indication de longueur qui indique la quantité de données de l'élément de canal respectif ou une quantité de données des données d'en-tête cohérentes respectives, dans lequel est placé devant le deuxième flux de données audio un en-tête d'ensemble qui présente une partie redondante identique pour tous les en-tête, aux caractéristiques suivantes:

un moyen destiné à former un flux de données d'entrée qui représente le signal audio codé et qui présente un premier format de fichier, à partir du deuxième flux de données audio

en vérifiant qu'il s'agisse, pour le deuxième flux de données audio, d'un flux de données reformaté à partir du premier de format de fichier;

en lisant la partie auparavant redondante identique de l'en-tête d'ensemble;

en remplaçant l'indication de longueur dans les en-tête par la partie auparavant redondante identique;

en réinitialisant les pointeurs dans les en-têtes des éléments de canal du deuxième flux de données audio de sorte qu'ils indiquent comme début des données audio d'en-tête que les données audio d'en-tête commencent immédiatement à la suite de l'en-tête respectif, pour obtenir des en-têtes réinitialisés;

en modifiant une indication de débit binaire dans les en-têtes des éléments de canal du deuxième flux de données audio de sorte qu'une longueur de bloc de données dépendant de l'indication de débit binaire selon le premier format de fichier audio dans tous les en-têtes soit suffisante pour recevoir l'en-tête respectif et les données audio d'en-tête associées, pour obtenir des en-têtes à débit binaire modifié et réinitialisés; et

en insérant des bits entre chaque élément de canal et l'élément de canal suivant de sorte que la longueur de chaque élément de canal plus les bits insérés soit adaptée à l'indication de débit binaire modifié, et

un moyen destiné à alimenter le flux de données d'entrée vers le décodeur selon l'indication de débit binaire modifié, pour obtenir le signal audio.

**12.** Dispositif selon la revendication 11, dans lequel la partie redondante identique pour tous les en-têtes est un mot de synchronisation.

**13.** Dispositif selon la revendication 11 ou 12, dans lequel le moyen destiné à former le flux de données d'entrée est conçu pour régler, en cas de modification de l'indication de débit binaire, ce dernier à une valeur maximale admissible.

**14.** Programme d'ordinateur avec un code de programme pour réaliser le procédé selon l'une des revendications 1 ou 8 lorsque le programme d'ordinateur est exécuté sur un ordinateur.

FIG. 1

30

AUDIO-
SIGNAL → MP3-
KODIERER → MP3-AUDIO-
DATENSTROM

32

MP3-MPEG4-
WANDLER → MPEG-4-AUDIO-
DATENSTROM

30'

FIG. 2

100

MPEG-4-AUDIO-
DATENSTROM → MP3-
REKONSTRUIERER

MP3-AUDIO-
DATENSTROM

102

MP3-
DEKODIERER → AUDIO-
SIGNAL

102'

FIG. 6

EMPFANGEN DES MP3-AUDIODATENSTROMS —40

ZUSAMMENFASSEN ALLER AUDIODATEN, DIE ZU EINER ZEITMARKE GEHÖREN, ZU EINEM ZUSAMMENHÄNGENDEN BLOCK FÜR ALLE ZEITMARKEN —42

ANFÜGEN DER HEADER AN DIE ZUSAMMENHÄNGENDEN BLÖCKE, UM KANALELEMENTE ZU ERHALTEN —50

MODIFIZIEREN DER HEADER DURCH ERSETZEN DES SYNCHRONISATIONSWORTES DURCH DIE LÄNGE DES JEWEILIGEN KANALELEMENTS —56

ERSTELLEN EINES DATEI-HEADERS AUDIOSPECIFICCONFIG —60

AUSGEBEN VON AUDIOSPECIFICCONFIG UND DER KANAL-ELEMENTE ALS MPEG-4-AUDIODATENSTROM —62

# FIG. 3

FIG. 4

FIG. 5

VON KODIERER 1 (FRONT)

| $h_F$ | $S_F$ | DATA 1 F | ... |

| | | DATA 2 F | ... |

VON KODIERER 2 (CENTER)

| $h_C$ | $S_C$ | DATA 1 C | ... |

| | | DATA 2 C | ... |

VON KODIERER 2 (SURROUND)

| $h_S$ | $S_S$ | DATA 1 S | ... |

| | | DATA 2 S | ... |

| $h_F$ | $S_F$ | DATA 1 F | $h_C$ | $S_C$ | DATA 1 C | $h_S$ | $S_S$ | DATA 1 S |

| DATA 0 F | FILL DATA 0 F | $H'_F$ | $S'_F$ | DATA 1 F | FILL DATA 1 F |

syncword=0xFFF | main_data_begin=0
ID | ...
layer
protection_bit
bitrate_index=0xE
sampling_frequency
padding_bit=1

MP3-DEKODIERER-INSTANZ

| DATA 0 F | FILL DATA 0 C | $H'_C$ | $S'_C$ | DATA 1 C | FILL DATA 1 C |

MP3-DEKODIERER-INSTANZ

length of frame is constant the allowed maximum

| DATA 0 F | FILL DATA 0 C | $H'_S$ | $S'_S$ | DATA 1 S | FILL DATA 1 S |

MP3-DEKODIERER-INSTANZ

VERIFIZIEREN, DASS ES SICH BEI DEM MPEG-4-DATENSTROM UM EINEN UMFORMATIERTEN MP3-DATENSTROM HANDELT, DURCH NACHSCHLAGEN IN DEN AUDIOSPECIFIGCONFIG ⌐∽118

GEWINNEN DER UNTER DEN HEADERN REDUNDANTEN TEILS SOWIE DER KANALKONFIGURATION AUS DER AUDIOSPECIFICCONFIG ⌐∽112

IN JEDEM KANALELEMENT, ERSETZEN DER KANALLÄNGENANGABE IM HEADER DURCH DAS SYNCHRONISATIONSWORT ⌐∽114

IN JEDEM KANALELEMENT, SETZEN DES ZEIGERS IN DEN SEITENINFORMATIONEN AUF 0 ⌐∽118

IN JEDEM KANALELEMENT, SETZEN DES BITRATENINDEX IM HEADER AUF DEN HÖCHSTEN ERLAUBTEN WERT ⌐∽122

ANFÜGEN VON FÜLLDATEN AN JEDES KANALELEMENT, UM DIE LÄNGE ALLER KANALELEMENTE EINHEITLICH AUF DIE MAXIMALE MP3-DATENBLOCKLÄNGE ZU VERGRÖSSERN ⌐∽128

WEITERLEITEN DER MODIFIZIERTEN KANALELEMENTE ALS DATEN-BLÖCKE EINES MP3-AUDIODATENSTROMS AN DEN JEWEILIGEN MP3-DEKODIERER ⌐∽130

FIG. 7

VERIFIZIEREN, DASS ES SICH BEI DEM MPEG-4-DATENSTROM UM EINEN UMFORMATIERTEN MP3-DATENSTROM HANDELT, DURCH NACHSCHLAGEN IN DEN AUDIOSPECIFIGCONFIG ⟩～150

GEWINNEN DER UNTER DEN HEADERN REDUNDANTEN TEILS SOWIE DER KANALKONFIGURATION AUS DER AUDIOSPECIFICCONFIG ⟩～152

IN JEDEM KANALELEMENT, ERSETZEN DER KANALLÄNGENANGABE IM HEADER DURCH DAS SYNCHRONISATIONSWORT ⟩～154

REKONSTRUIEREN DER URSPRÜNGLICHEN DATENBLOCKLÄNGE AUF DER BASIS DER ABTASTRATE, DER BITRATE UND DES PADDING-BITS IN DEN HEADERN ⟩～156

BILDEN DES MP3-AUDIODATENSTROMS DURCH ANEINANDERREIHEN DER HEADER IM ABSTAND DER DATENBLOCKLÄNGE UND AUSFÜLLEN DER ZWISCHENRÄUME DURCH EINFÜGEN DER AUDIO-DATEN AN DEN DURCH DEN ZEIGER IN DEN HEADERN ANGEGEBENEN POSITIONEN ⟩～158

FIG. 8

EMPFANGEN DES MP3-AUDIODATENSTROMS — 40

ZUSAMMENFASSEN ALLER AUDIODATEN, DIE ZU EINER ZEITMARKE GEHÖREN, ZU EINEM ZUSAMMENHÄNGENDEN BLOCK FÜR ALLE ZEITMARKEN — 42

ANFÜGEN DER HEADER AN DIE ZUSAMMENHÄNGENDEN BLÖCKE, UM KANALELEMENTE ZU ERHALTEN — 50

MODIFIZIEREN DER HEADER DURCH ERSETZEN DES SYNCHRONI-SATIONSWERTES DURCH DIE LÄNGE DES JEWEILIGEN KANALELEMENTS — 56

IN JEDEM KANALELEMENT, SETZEN DES ZEIGERS IN DEN SEITEN-INFORMATIONEN AUF 0 — 180

IN JEDEM KANALELEMENT, SETZEN DES BITRATENINDEX IM HEADER AUF EINEN WERT, DER EINER AUSREICHENDEN MP3-FRAMELÄNGE ENTSPRICHT — 182

EINSTELLEN EINES DATEI-HEADERS AUDIOSPECIFICCONFIG — 60

AUSGEBEN VON AUDIOSPECIFICCONFIG UND DER KANALELEMENTE ALS MPEG-4-AUDIODATENSTROM — 62

FIG. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2003009246 A1

**In der Beschreibung aufgeführte Nicht-Patentliteratur**

- **FINLAYSON R.** *A more loss tolerant RTP payload format for MP3 audio,* Juni 2001, ht-tp.//www.faqs.org/rfcs/ rfc3119.htm1